# EUROPÄISCHE PATENTSCHRIFT

(11) **EP 3 046 191 B1**
(45) Veröffentlichungstag und Bekanntmachung des Hinweises auf die Patenterteilung: **17.04.2019**
(21) Anmeldenummer: 15201560.8
(22) Anmeldetag: 21.12.2015
(51) Int. Cl.: H01S 3/067, H01S 3/082, H01S 3/098, H01S 3/10, H01S 3/106

(54) **ULTRAKURZPULSFASERLASER**
ULTRA SHORT PULSE FIBER LASER
LASER A FIBRES A IMPULSIONS ULTRACOURTES

(30) Priorität: 13.01.2015 DE 102015200366
(43) Veröffentlichungstag der Anmeldung: 20.07.2016
(73) Patentinhaber: Deutsches Elektronen-Synchrotron DESY, 22607 Hamburg (DE)
(72) Erfinder: BARRE, Damian, 22605 Hamburg (DE); KÄRTNER, Franz, 22559 Hamburg (DE)
(74) Vertreter: Seemann & Partner Patentanwälte mbB

(56) Entgegenhaltungen:
- WEI-WEI HSIANG ET AL: "Passive synchronization between a self-similar pulse and a bound-soliton bunch in a two-color mode-locked fiber laser", OPTICS LETTERS, OPTICAL SOCIETY OF AMERICA, US, Bd. 34, Nr. 13, 1. Juli 2009 (2009-07-01), Seiten 1967-1969, XP001524116, ISSN: 0146-9592
- L. YUN: "All-fiber laser simultaneously delivering multi-wavelength solitons", OPTICS COMMUNICATIONS., Bd. 322, 1. Juli 2014 (2014-07-01), Seiten 61-65, XP55271057, NL ISSN: 0030-4018, DOI: 10.1016/j.optcom.2014.02.007
- NOSKE D U ET AL: "Dual-wavelength operation of a passively mode-locked ''figure-of-eight'' ytterbium-erbium fibre soliton laser", OPTICS COMMUNICATIONS, NORTH-HOLLAND PUBLISHING CO. AMSTERDAM, NL, Bd. 108, Nr. 4-6, 1. Juni 1994 (1994-06-01), Seiten 297-301, XP024506638, ISSN: 0030-4018, DOI: 10.1016/0030-4018(94)90666-1 [gefunden am 1994-06-01]

## Beschreibung

Die Erfindung betrifft einen passiv modengekoppelten Ultrakurzpulsfaserlaser zum Erzeugen ultrakurzer Laserpulse, umfassend einen Resonator in achtförmiger Konfiguration, wobei der Resonator einen Hauptring und einen an diesen optisch gekoppelten, als nichtlineares Sagnac-Interferometer ausgestalteten Nebenring aufweist, und wobei der Hauptring und der Nebenring aus polarisationserhaltenden Lichtleitfasern aufgebaut sind und der Hauptring und/oder der Nebenring einen als laseraktives Medium ausgebildeten Faserabschnitt aufweisen, wobei das laseraktive Medium optisch durch eine außerdem umfasste, extern-gekoppelte Pumplichtquelle gepumpt wird.

Ultrakurze Laserpulse haben vielfältige Anwendungen, die von der Informationstechnologie bis zur Materialbearbeitung reichen. Zur Erzeugung ultrakurzer Laserpulse werden beispielsweise Faserlaser eingesetzt, bei denen im Resonator das Laserlicht in einer Lichtleitfaser geführt wird. Eine entsprechend dotierte Lichtleitfaser oder ein dotierter Faserabschnitt dienen als Laser-Verstärkermedium. Je nach Laserwellenlänge kommen verschiedene Dotierelemente in Betracht, vor allem seltene Erden.

Es sind modengekoppelte Ultrakurzpulsfaserlaser bekannt, die in achtförmiger Konfiguration aufgebaut sind. Ein solcher Laser ist beispielsweise aus US 2008/0144676 A1 bekannt. Die Modenkopplung erfolgt aktiv oder passiv. Bei aktiver Modenkopplung wird beispielsweise ein elektrooptischer oder akustooptischer Modulator im Resonator angeordnet.

Für modengekoppelte Ultrakurzpulsfaserlaser werden vielfach Fasern oder Faserabschnitte mit normaler und mit anomaler Dispersion kombiniert. Wobei im Kontext der vorliegenden Beschreibung Dispersion für Gruppenlaufzeitdispersion, d.h. Pulsverbreiterung pro spektrale Bandbreite (in Kreisfrequenz), steht. Im Fall normaler Dispersion in einer Faser mit fester Länge wird die Gruppengeschwindigkeit mit der Frequenz kleiner. Im Fall anomaler Dispersion erhöht sich die die Gruppengeschwindigkeit mit der Frequenz.

Durch die Kombination von Lichtleitfasern mit gegensätzlicher Dispersion ist es möglich, die beim Durchlauf der Lichtpulse in den Fasern auftretende Dispersion zu kompensieren. Abhängig vom jeweiligen Spektralbereich sind Lichtleitfasermodule mit entsprechender Dispersion für Dispersionskompensation bei gleichzeitigem Monomode-Betrieb schlecht verfügbar und dementsprechend aufwendig zu erzeugen und teuer. Ferner ist das Spleißen an eine konventionelle Faser technisch anspruchsvoll.

In US 2008/0144676 A1 ist ein Aufbau vorgeschlagen, bei dem Komponenten Verwendung finden, welche normale und anomale Dispersion aufweisen. Um den Ultrakurzpulsfaserlaser zu starten, ist in einen der beiden Ringe der achtförmigen Konfiguration ein Modulator integriert. Dieser ist mit einer externen Signalquelle gekoppelt, die mit der Frequenz des Lasers betrieben wird.

Aus C. Aguergaray, R. Hawker, A. F. J. Runge, M. Erkintalo, and N. G. R. Broderick: "120 fs, 4.2 nJ pulses from an all-normaldispersion, polarization-maintaining, fiber laser", Appl. Phys. Lett. 103, 121111 (2013) geht ein Aufbau für einen Ultrakurzpulsfaserlaser hervor, in dessen achtförmige Konfiguration ein optischer Bandpassfilter integriert ist. Dieser dient zur Erzeugung einer selbstkonsistenten Pulsausbreitung und Unterstützung der passiven Modenkopplung. Ein Modulator muss hier nicht verwendet werden, da der Laser selbststartend ist. Eine Laserkonfiguration bestehend gänzlich aus normal dispersiven Komponenten und einem Bandpassfilter wird auch als sog. ANDI-Aufbau (ANDI für engl.: all normal dispersion) bezeichnet.

Ein weiterer Faserlaser ist aus US 2008/0025348 A1 bekannt. Dieser umfasst einen Hauptring und einen Verstärkungsring, welche aus Fasern mit unterschiedlicher Dispersion aufgebaut sind. Der Verstärkungsring ist aus Fasern mit positiver Dispersion, der Hauptring zumindest abschnittsweise aus Fasern mit negativer Dispersion aufgebaut. Um eine vollständige Dispersionskompensation zu erreichen, ist in den Hauptring ein ebenfalls aus Fasern aufgebauter Dispersionskompensator integriert. Dieser umfasst zwei gechirpte Faser-Bragg-Gitter, mit denen eine differenzielle Dispersionskompensation bewirkt wird.

Aus Wei-Wei Hsiang et al.: "Passive synchronization between a self-similar pulse and a bound-soliton bunch in a two-color mode-locked fiber laser", Optics Letters, Optical Society of America, US, Bd. 34, Nr. 13, 1. Juli 2009, Seiten 1967-1969, ist ein optischer Aufbau bekannt, bei dem zwei Resonatorringe miteinander gekoppelt werden. In einem ersten Resonatorring, der aus einer Yb-Glasfaser aufgebaut ist, propagieren Pulse mit einer Wellenlänge von 1 µm. In einem zweiten Ring, der aus einer Er-Glasfaser aufgebaut ist, propagieren Pulse mit einer Wellenlänge von 1,5 µm. Diese beiden Farben werden modengekoppelt aus dem optischen Aufbau ausgekoppelt.

Ferner ist aus L. Yun: "All-fiber laser simultaneously delivering multi-wavelength solitons", Optics Communications, Bd. 322, 1. Juli 2014, Seiten 61-65, ein NALM-Laser (nonlinear amplifying loop mirror) bekannt, in dessen Hauptring mehrere gechirpte Faser-Bragg-Gitter über einen optischen Zirkulator optisch eingebunden sind. Die gechirpten Faser-Bragg-Gitter dienen der Kompensation einer Gruppenlaufzeitdispersion der erzeugten Laserpulse.

Ferner ist aus Noske D.U. et al.: "Dual-wavelength operation of a passively mode-locked "figure-of-eight" ytterbium-erbium fiber soliton laser" Optics Communications, Bd. 108, Nr. 4-6, 1. Juni 1994, Seiten 297-301, ein weiterer NALM-Laser bekannt, welcher vollständig in Lichtleitfasern aufgebaut ist. In dieses sogenannte "All-Fiber Design" ist ein Faser-Bragg-Gitter integriert, welches als Abstimmungselement dient.

Ausgehend von diesem Stand der Technik ist es eine Aufgabe der Erfindung, einen passiv modengekoppelten Ultrakurzpulsfaserlaser anzugeben, der gegenüber äußeren Einflüssen stabil ist.

Die Aufgabe wird gelöst durch einen passiv modengekoppelten Ultrakurzpulsfaserlaser zum Erzeugen ultrakurzer Laserpulse, umfassend einen Resonator in achtförmiger Konfiguration, wobei der Resonator einen Hauptring und einen an diesen optisch gekoppelten, als nichtlineares Sagnac-Interferometer ausgestalteten Nebenring aufweist, und wobei der Hauptring und der Nebenring aus polarisationserhaltenden Lichtleitfasern aufgebaut sind und der Hauptring und/oder der Nebenring einen als laseraktives Medium ausgebildeten Faserabschnitt aufweisen, wobei das laseraktive Medium optisch durch eine außerdem umfasste, extern-gekoppelte Pumplichtquelle gepumpt wird, wobei der Ultrakurzpulsfaserlaser dadurch fortgebildet ist, dass im Resonator eine Dispersionskompensationseinheit zur Kompensation einer Gruppenlaufzeitdispersion der ultrakurzen Laserpulse vorhanden ist, wobei die Dispersionskompensationseinheit eine separate optische Einheit ist und wobei die Dispersionskompensationseinheit zumindest ein Dispersionskompensationselement umfasst und an einem Eingang und/oder einem Ausgang der Dispersionskompensationseinheit zwischen einem ersten Ende und/oder einem zweiten Ende der Lichtleitfaser des Hauptrings und/oder des Nebenrings und dem Dispersionskompensationselement eine Freistrahlstrecke vorhanden ist, so dass das Dispersionskompensationselement eine von der Lichtleitfaser separate, insbesondere räumlich und optisch getrennte, optische Einheit bildet, und wobei an einem Ausgang der Dispersionskompensationseinheit ein Polarisationsanpassungselement vorhanden ist, wobei das Polarisationsanpassungselement zum Anpassen eines Polarisationszustandes eines die Dispersionskompensationseinheit verlassenden Laserpulses an eine Polarisationsrichtung der Lichtleitfaser eingerichtet ist, wobei am Ausgang der Dispersionskompensationseinheit ein Lyot-Filter vorhanden ist, welcher einen Polarisator und einen Analysator sowie einen zwischen dem Polarisator und dem Analysator angeordneten doppelbrechenden Kristall umfasst, wobei als Polarisationsanpassungselement der Analysator des Lyot-Filters vorgesehen ist.

Das Dispersionskompensationselement ist eine von der Lichtleitfaser separate optische Einheit.

Der Hauptring und der Nebenring sind faserbasierte Ringe. Mit anderen Worten werden die in den Ringen propagierenden Lichtpulse im weit überwiegenden Teil der Strecke in Lichtleitfasern geführt. Im Hauptring ist bevorzugt ein optischer Isolator oder ein optischer Zirkulator vorhanden, der die Propagationsrichtung, also die Richtung der Pulsausbreitung, im Hauptring vorgibt.

Der erfindungsgemäße Ultrakurzpulsfaserlaser weist unter anderem die folgenden Vorteile auf: Durch die selbststartende passive Modenkopplung durch die Kombination aus Neben- und Hauptring entfällt die Notwendigkeit für eine aktive Modenkopplung einschließlich der dazugehörigen vielfach aufwendigen Steuerelektronik und Modulatoren. Durch die Verwendung von polarisationserhaltenden Lichtleitfasern ist der Aufbau gegenüber Umwelteinflüssen stabil, beispielsweise gegenüber Temperaturschwankungen oder Erschütterungen. Es wird eine exzellente Pulsqualität erreicht, diese zeigt sich durch kurzen Pulsdauern und der Unterdrückung von störendem Pulsuntergrund. Darüber hinaus weist das Spektrum eine gute Form auf; vor allem wird das Auftreten unerwünschter Seitenbänder im spektralen Spektrum minimiert oder gar vollständig vermieden. Die verwendeten Komponenten des Lasers sind weitgehend justagefrei. Die vielfach bei passiv modengekoppelten Ultrakurzpulsfaserlasern notwendigen sättigbaren Absorber, welche bei bekannten Systemen im Resonator angeordnet werden, entfallen ebenfalls vorteilhaft.

Die genannten Vorteile werden erreicht, indem eine Dispersionskompensationseinheit im Resonator des Ultrakurzpulsfaserlasers angeordnet wird, wobei die Dispersionskompensationseinheit eine separate optische Einheit ist und wobei die Dispersionskompensationseinheit zumindest ein Dispersionskompensationselement umfasst und an einem Eingang und/oder einem Ausgang der Dispersionskompensationseinheit, zwischen einem ersten Ende und/oder einem zweiten Ende der Lichtleitfaser des Hauptrings und/oder des Nebenrings und dem Dispersionskompensationselement eine Freistrahlstrecke vorhanden ist, so dass das Dispersionskompensationselement eine von der Lichtleitfaser separate optische Einheit bildet.

Mit dem Ultrakurzpulsfaserlaser gemäß Aspekten der Erfindung können Pulsdauern von weniger als 100 fs bei Repetitionsraten von mehr als 100 kHz, insbesondere bei Repetitionsraten von in etwa 20 MHz, erreicht werden. Solche Repetitionsrate ist beispielsweise für industrielle Anwendungen wie Laserbohren oder Laserschneiden, aber auch für Anwendungen in der Medizintechnik, beispielsweise in der Zweiphotonenspektroskopie, vorteilhaft.

Bei dem passiv modengekoppelten Ultrakurzpulsfaserlaser gemäß der Erfindung ist vorgesehen, dass ausschließlich polarisationserhaltende Lichtleitfasern zum Einsatz kommen. Insbesondere ist vorgesehen, dass ausschließlich einmodige und grundmodige Lichtleitfasermodule verwendet werden.

Sofern der Ultrakurzpulsfaserlaser bei einer mittleren Wellenlänge von ca. 1 µm betrieben wird, kommen ferner bevorzugt ausschließlich Lichtleitfasern mit normaler Dispersion zum Einsatz.

Bevorzugt ist ferner vorgesehen, dass das laseraktive Medium mit einem der folgenden Elemente dotiert ist: Ytterbium (Yb), Erbium (Er), Thulium (Tm), Holmium (Ho), Neodym (Nd), Praseodym (Pr). Welches der genannten Elemente als Dotierung für das laseraktive Medium verwendet wird, hängt vom jeweiligen Anwendungszweck und der gewünschten mittleren Laserwellenlänge ab.

Gemäß weiterer Ausführungsbeispiele, in denen das laseraktive Medium mit zumindest einem der Elemente: Erbium (Er), Thulium (Tm) oder Holmium (Ho) dotiert ist, liegt die Laserwellenlänge in einem Spektralbereich in dem die Lichtleitfasern bevorzugt anomale Dispersion aufweisen, daher kommt anomale Dispersion bevorzugt zum Einsatz.

Gemäß einer vorteilhaften Ausführungsform umfasst der Nebenring einen Abschnitt aus einer nichtlinearen Lichtleitfaser und die Dispersionskompensationseinheit ist in dem Nebenring angeordnet. Insbesondere ist außerdem ein als laseraktives Medium ausgebildeter Faserabschnitt in dem Nebenring vorgesehen.

Im Kontext der vorliegenden Beschreibung wird unter einer nichtlinearen Lichtleitfaser eine Faser verstanden, die die Funktion hat, die nichtlineare Phase aufzusammeln, die für die Operation des nichtlinearen Sagnac-Interferometers essentiell ist.

Der Ultrakurzpulsfaserlaser ist ferner dadurch fortgebildet, dass der Hauptring und der Nebenring über einen Koppler gekoppelt sind, wobei die Dispersionskompensationseinheit im Nebenring direkt anschließend zu dem Koppler angeordnet ist. Mit anderen Worten durchläuft ein in den Nebenring eingekoppelter Laserpuls zuerst die Dispersionskompensationseinheit und anschließend ein optional in dem Nebenring vorhandenes laseraktives Medium. So werden die Verluste der Dispersionskompensationseinheit von dem nachgeschalteten Verstärker kompensiert, darüber hinaus wird unabhängig von der Intensität des eintretenden Laserpulses am Ausgang stets Laserpulse mit einer vorgegebenen erhöhten Ausgangsintensität bereitstellt.

Gemäß einer weiteren Ausführungsform ist vorgesehen, dass die Dispersionskompensationseinheit und der Abschnitt aus der nichtlinearen Lichtleitfaser unmittelbar benachbart zueinander angeordnet sind, so dass ein in dem Nebenring propagierender Laserpuls, welcher zur Kompensation seiner Gruppenlaufzeitdispersion die Dispersionskompensationseinheit durchlaufen hat, direkt anschließend in den Abschnitt aus der nichtlinearen Lichtleitfaser eintritt, wobei der Nebenring kein laseraktives Medium umfasst.

Die im nichtlinearen Faserabschnitt auftretenden nichtlinearen Effekte sind Intensitätsabhängig. Ein Laserpuls, dessen Gruppenlaufzeitdispersion (von Dispersionskompensationseinheit) kompensiert wurde, weist eine gegenüber dem unkompensierten und somit auch unkomprimierten Laserpuls höhere Pulsspitzenintensität auf. Der komprimierte Laserpuls, welcher die Dispersionskompensationseinheit verlässt, ruft daher in dem nichtlinearen Faserabschnitt vergleichbare nichtlineare Effekte hervor, wie dies ein verstärkter nicht-komprimierter Laserpuls, tun würde. So ist es möglich, auf einen Verstärker, d.h. auf ein laseraktives Medium, im Nebenring zu verzichten.

Die vorteilhafte Ausführungsform, bei der die Dispersionskompensationseinheit im Nebenring, und zwar direkt hinter dem Koppler, angeordnet ist, stellt eine asymmetrische Anordnung in der nichtlinearen Sagnac-Schleife dar. Bei einer solchen asymmetrischen Verwendung der Dispersionskompensationseinheit direkt hinter dem Koppler müssen die Laserpulse, welche in die nichtlineare Sagnac-Schleife, also den Nebenring, eingekoppelt werden gechirpt oder gestreckt sein. Die Dispersionskompensationseinheit kompensiert überwiegend den aufgeprägten Chirp. Allerdings geschieht dies je nach Umlaufrichtung durch die Sagnac-Schleife vor oder nach der nichtlinearen Pulsausbreitung. Die überwiegende Kompensation des Chips durch die Dispersionskompensationseinheit hat den Vorteil, dass nach dem Durchlauf der Dispersionskompensationseinheit eine höhere Pulsspitzenleistung vorliegt. Eine höhere Pulsspitzenleistung erlaubt eine erhöhte Nichtlinearität beispielsweise in Form des nichtlinearen Effekts der Selbst-Phasenmodulation. Die asymmetrische Anordnung hat den Vorteil, dass die akkumulierte nichtlineare Phase in beiden Umlaufrichtungen unterschiedlicher wird. Dies ist für die Funktion der nichtlinearen Sagnac-Schleife essenziel. So ist es möglich, dass in bestimmten Fällen sogar ganz auf den Einsatz des Faserverstärkers in der nichtlinearen Sagnac-Schleife verzichtet werden kann, mit anderen Worten also im Nebenring kein laseraktives Medium vorhanden ist. Dies senkt die Herstellungskosten des Lasers erheblich.

In diesem Zusammenhang ist es ebenfalls möglich, zwei Dispersionskompensationsmodule vorzusehen, und zwar ein erstes Modul vor dem Koppler zum Nebenring (nichtlineare Sagnac-Schleife) und ein weiteres und eigentliches Dispersionskompensationsmodul asymmetrisch hinter einem der Ausgänge des Kopplers in dem Nebenring. So ist gemäß einer weiteren Ausführungsform vorgesehen, dass eine erste Dispersionskompensationseinheit im Hauptring und eine zweite Dispersionskompensationseinheit im Nebenring vorhanden sind.

Ferner ist der Ultrakurzpulsfaserlaser gemäß Aspekten der Erfindung dadurch fortgebildet, dass der Nebenring zumindest abschnittsweise aus einer hoch-nichtlinearen Lichtleitfaser aufgebaut ist oder einen hoch-nichtlinearen Lichtleitfaserabschnitt umfasst, wobei der Fasernichtlinearitätsfaktor des hoch-nichtlinearen Lichtleitfaserabschnitts größer als drei, insbesondere größer als fünf, ferner insbesondere größer als sieben, weiterhin insbesondere größer als acht, weiterhin insbesondere größer als zehn und ferner insbesondere größer als dreizehn ist, wobei der Fasernichtlinearitätsfaktor in der Einheit 1 / (W * km) betrachtet wird.

Mit anderen Worten wird im Kontext der vorliegenden Beschreibung unter einer hoch-nichtlinearen Lichtleitfaser eine Lichtleitfaser mit einem Fasernichtlinearitätsfaktor von größer als drei 1 / (W * km), insbesondere größer als einem der weiteren genannten Werte, verstanden.

Durch die Verwendung einer hoch-nichtlinearen Lichtleitfaser ist es möglich, diese wesentlich kürzer als bei bisher bekannten Lasern auszugestalten. Wichtig ist in diesem Zusammenhang, dass trotz der geringeren Länge der Lichtleitfaser das Produkt aus Länge der Faser und deren Nichtlinearitätsfaktor γ ähnliche Werte erreicht, wie sie von herkömmlichen Lasern bekannt sind. Vorteilhaft führt die geringere Länge der Lichtleitfaser jedoch zu verkürzten Umlaufzeiten der Laserpulse im Resonator. Durch diese Maßnahme ist es möglich, die Repetitionsrate des Lasers zu erhöhen. Beispielsweise ist eine Steigerung der Repetitionsrate von 10 MHz bis in den Bereich von 20 MHz oder mehr möglich.

Um die Repetitionsrate unter 1 MHz zu bringen ist gemäß Aspekten der Erfindung vorgesehen, einen optischen Zirkulator und eine längere polarisationserhaltende oder polarisierende Lichtleitfaser in Doppelpasskonfiguration vorzusehen. Mit anderen Worten wird der als Doppelpass ausgestaltete Faserabschnitt sowohl in Hin- als auch in Rückrichtung durchlaufen und somit optisch doppelt genutzt. Durch die Doppelpasskonfiguration kann erheblich Faserlänge eingespart werden, was einen Kostenvorteil bedeutet.

Gemäß einer Ausführungsform, die als Doppelpasskonfiguration realisiert ist, ist vorgesehen, dass im Hauptring ein optischer Zirkulator mit einem ersten bis dritten Anschluss vorhanden ist, wobei der Zirkulator derart in den Hauptring integriert ist, dass in dem Hauptring in einer Propagationsrichtung propagierende Laserpulse am ersten Anschluss in den Zirkulator eingekoppelt und von dem Zirkulator an den zweiten Anschluss weitergeleitet werden, wobei mit dem zweiten Anschluss ein Verzögerungs-Faserabschnitt des Hauptrings gekoppelt ist, an dessen dem Zirkulator abgewandtem Ende ein Umkehrspiegel vorhanden ist, der dazu eingerichtet ist, den Verzögerungs-Faserabschnitt durchlaufende Laserpulse zurück in den Verzögerungs-Faserabschnitt zu reflektieren, und wobei Laserpulse, welche den Verzögerungs-Faserabschnitt von dem Umkehrspiegel kommend durchlaufen haben am zweiten Anschluss in den Zirkulator eingekoppelt und von dem Zirkulator an den dritten Anschluss weitergeleitet werden, so dass der Laserpuls in der Propagationsrichtung im Hauptring propagiert. Der Verzögerungs-Faserabschnitt ist Teil des Resonators und wird im Doppelpass durchlaufen.

Im Kontext der vorliegenden Beschreibung wird unter einem Umkehrspiegel nicht nur ein als separates optisches Bauelement ausgeführter Spiegel, sondern auch ein als Umkehrspiegel wirkendes beispielsweise faserbasiertes optisches Element verstanden. So ist es beispielsweise vorgesehen, dass am dem Zirkulator abgewandten Ende des Verzögerungs-Faserabschnitts ein Faser-Bragg-Gitter vorhanden ist.

Gemäß einer vorteilhaften Weiterbildung des Ultrakurzpulsfaserlasers ist der Umkehrspiegel gleichzeitig als Auskoppelspiegel zum Auskoppeln der im Resonator propagierenden Laserpulse ausgestaltet. Vorteilhaft weist der Umkehrspiegel also eine Doppelfunktion auf, so dass ein optisches Element eingespart werden kann.

Auch in einem Fall, in dem der Umkehrspiegel gleichzeitig als Auskoppelspiegel wirkt, ist es vorgesehen, dass dieser als ein optisches Element ausgestaltet ist, das als Umkehrspiegel wirkt. Insbesondere ist ebenfalls ein faserbasiertes optisches Element vorgesehen, beispielsweise ein Faser-Bragg-Gitter.

Befindet sich kein Zirkulator im Hauptring des Ultrakurzpulsfaserlasers, wird die Propagationsrichtung der Laserpulse im Hauptring durch einen in den Hauptring integrierten optischen Isolator festgelegt.

Ferner ist vorgesehen, dass die nichtlineare polarisationserhaltende Faser im Nebenring so ausgewählt wird, dass diese eine niedrige Dispersion hat. Die Dispersion der Faser wäre für eine Laserwellenlänge von 1 µm zwar noch normal, jedoch betragsmäßig sehr gering. Da diese Faser ca. 30 - 70% der gesamten Faserlänge darstellt, wird somit die gesamte Dispersion des Lasers geringer. Dies hat den Vorteil, dass in Folge der geringeren auftretenden Dispersion auch die Dispersionskompensation noch einmal wesentlich kompakter wird.

Insbesondere ist der Ultrakurzpulsfaserlaser dadurch fortgebildet, dass die Dispersionskompensationseinheit als Dispersionskompensationselement zumindest eines der folgenden optischen Elemente umfasst:
- zumindest einen gechirpten Spiegel, insbesondere zwei zueinander plan-parallel angeordnete gechirpte Spiegel,
- zumindest einen Gires-Tournois-Interferometer (GTI) - Spiegel, insbesondere zwei zueinander plan-parallel angeordnete Gires-Tournois-Interferometer (GTI) - Spiegel,
- zumindest ein optisches Gitter, insbesondere zwei zueinander plan-parallel angeordnete optische Gitter und einen Umkehrspiegel,
- zumindest ein Volumen-Bragg-Gitter,
- zumindest ein Prisma,
- zumindest ein Gitterprisma,
- zumindest ein gechirptes Faser-Bragg-Gitter.

Wird die Dispersionskompensation durch faserbasierte optische Elemente erzeugt, so ist bevorzugt eine Kombination eines optischen Zirkulators und eines gechirpten Faser-Bragg-Gitters vorgesehen.

Das Einbringen eines Zirkulators erlaubt darüber hinaus das Anspleißen einer langen polarisationserhaltenden oder polarisierenden Faser, die im Doppelpass durchlaufen wird. Dies hat den Vorteil, dass nur die Hälfte solch einer kostenintensiven Komponente verwendet werden muss. Es werden jedoch nicht nur die Herstellungskosten des Lasers gesenkt, bei dieser Realisierung werden auch besonders geringe Pulswiederholungsraten im Bereich von 100 kHz und kleiner als 5 MHz erreicht.

Im Kontext der vorliegenden Beschreibung ist ein gechirpter Spiegel ein dielektrischer Spiegel mit variabler Bragg-Struktur. Es handelt sich mit anderen Worten um ein Schichtpaket (engl. multilayer) aus einer Abfolge von aufeinanderfolgenden Doppelschichten, deren Einzelschichten stark unterschiedliche Brechungsindizes aufweisen. Ein beispielsweise vorgesehenes Materialsystem ist Silizium/Hafnium (Si/Hf). Bei einem gechirpten Spiegel ändert sich die Stapelrichtung, also senkrecht zur Ebene der Einzelschichten, die Schichtdicke einer Doppellage. Die unterschiedlichen Wellenlängen eines einfallenden Laserpulses werden in unterschiedlicher Tiefe des dielektrischen Spiegels (durch konstruktive Interferenz) reflektiert. Hierdurch ergibt sich ein Laufzeitunterschied für die unterschiedlichen Frequenz- bzw. Wellenlängenkomponenten des Lichtpulses. Im Ergebnis wird so die Dispersion des Laserpulses kompensiert, der Puls wird zeitlich komprimiert.

Alternativ zu einem gechirpten Spiegel wird ein Gires-Tournois-Interferometer - Spiegel (auch als GTI - Spiegel bekannt) eingesetzt. Dieser erzeugt ebenso wie ein geeignetes optisches Gitter, Prismen, Faser-Bragg-Gitter oder ein Volumen-Bragg-Gitter einen vergleichbaren optischen Effekt. Welches der zuvor genannten optischen Elemente zum Einsatz kommt, wird anhand des jeweiligen Anwendungsprofils entschieden.

Gemäß einer weiteren Ausführungsform ist vorgesehen, dass der zumindest eine gechirpte Spiegel, insbesondere die beiden gechirpten Spiegel, hoch dispersive gechirpte Spiegel sind.

Im Kontext der vorliegenden Beschreibung soll unter einem hoch dispersiven gechirpten Spiegel ein solcher Spiegel verstanden werden, dessen Absolutbetrag des Wertes der Gruppenlaufzeitdispersion (engl. group delay dispersion) einen Wert von minimal 1000 fs² aufweist.

Selbstverständlich ist auch eine Kombination der oben genannten optischen Elemente in einem gemeinsamen Dispersionskompensationselement möglich. Vorteilhaft werden die Integration von anomal dispersiven optischen Fasern und die damit verbundenen technischen Probleme vermieden, beispielsweise im Hinblick an deren Spleißbarkeit an herkömmliche Fasern. Ferner sind die genannten optischen Elemente einfach aufgebaut, daher mechanisch stabil und kostengünstig verfügbar.

Erfindungsgemäß ist ferner vorgesehen, dass an einem Ausgang der Dispersionskompensationseinheit ein Polarisationsanpassungselement vorhanden ist, wobei das Polarisationsanpassungselement zum Anpassen eines Polarisationszustandes eines die Dispersionskompensationseinheit verlassenden Laserpulses an eine Polarisationsrichtung der Lichtleitfaser eingerichtet ist.

Bevorzugt werden ein erstes Polarisationsanpassungselement am Eingang der Dispersionskompensationseinheit und ein zweites Polarisationsanpassungselement am Ausgang der Dispersionskompensationseinheit vorgesehen.

Die Polarisationsanpassungselemente dienen der Anpassung des Polarisationszustandes eines in dem Resonator propagierenden Laserpulses an die Dispersionskompensationseinheit. So wird ein Laserpuls, der aus einem ersten Ende der Lichtleitfaser austritt, unter Berücksichtigung der Polarisationseigenschaft des Dispersionskompensationselements an den Polarisationszustand der Lichtleitfaser, in deren zweites Ende der Laserpuls wieder eingekoppelt wird, angepasst.

Zur Ausbreitung der Laserpulse soll die langsame Polarisationsachse der Lichtleitfaser verwendet werden, da diese Aufgrund des höheren effektiven Ausbreitungsindexes keine Überkopplung in die andere Achse erlaubt.

Ein Polarisationsanpassungselement ist im Kontext der vorliegenden Beschreibung ein die Polarisation des Laserpulses veränderndes bzw. anpassendes optisches Modul oder Element.

Als polarisationsanpassendes Modul ist insbesondere eine λ/2- oder λ/4-Platte vorgesehen. Während eine λ/2-Platte die Anpassung der Polarisationsebene durch Rotation bei linear polarisiertem Licht erlaubt, erzeugt eine λ/4-Platte aus linear polarisiertem Licht zirkular polarisiertes Licht und umgekehrt. Die Verwendung einer λ/4-Platte ist insbesondere im Zusammenhang mit einem reflektierenden dispersionskompensierenden Element vorteilhaft. Durch die Reflektion kann die Richtung der Ausbreitung geändert werden. Ebenso ist eine Kombination beider oder mehrerer solcher Elemente vorgesehen. Optional werden diese durch einen oder mehrere Polarisatoren bzw. Analysatoren oder andere polarisierende Elemente ergänzt. Auch der Einsatz eines dünnen doppelbrechenden Kristalls ist möglich. Es ist ferner möglich, einen festeinstellbaren drehbaren Faserhalter vorzusehen, so dass die ausgezeichnete Polarisationsachse an den einfallenden Polarisationszustand anpassbar ist.

Am Ausgang der Dispersionskompensationseinheit ist ein Lyot-Filter vorhanden, welcher einen Polarisator und einen Analysator sowie einen zwischen dem Polarisator und dem Analysator angeordneten doppelbrechenden Kristall umfasst, wobei als Polarisationsanpassungselement der Analysator des Lyot-Filters vorgesehen ist. Mit anderen Worten erfüllt der Analysator des Lyot-Filters eine Doppelfunktion. Diese Ausführung bewirkt zusätzlich zur Anpassung der Polarisation auch eine vorteilhafte spektrale Filterung.

Gemäß einer vorteilhaften Weiterbildung ist ferner vorgesehen, dass zum Anpassen eines Polarisationszustandes des am ersten Ende aus der Lichtleitfaser austretenden und in das Dispersionskompensationselement eintretenden Laserpulses am Eingang der Dispersionskompensationseinheit, zwischen dem ersten Ende der Lichtleitfaser und dem Dispersionskompensationselement das erste Polarisationsanpassungselement vorhanden ist und zum Anpassen eines Polarisationszustandes eines aus dem Dispersionskompensationselement austretenden und an einem zweiten Ende in die Lichtleitfaser eintretenden Laserpulses am Ausgang der Dispersionskompensationseinheit, zwischen dem Dispersionskompensationselement und dem zweiten Ende der Lichtleitfaser ein zweites Polarisationsanpassungselement vorhanden ist.

Falls das Dispersionskompensationselement polarisationsunabhängige Eigenschaften aufweist, kann das Polarisationsanpassungselement vor oder nach dem Dispersionskompensationselement angeordnet werden.

Ferner ist insbesondere vorgesehen, dass der Ultrakurzpulsfaserlaser einen außerhalb des Resonators vorhandenen externen Pulskompressor umfasst. Dieser Pulskompressor ist insbesondere ausgestattet mit optischen Elementen, wie sie von der Dispersionskompensationseinheit bekannt sind. Beispielsweise umfasst der externe Pulskompressor zumindest einen gechirpten Spiegel oder GTI-Spiegel, insbesondere zwei zueinander plan-parallel angeordnete gechirpte Spiegel oder GTI-Spiegel. Ferner ist es möglich, den externen Pulskompressor aus zumindest einem optischen Gitter, insbesondere zwei optischen Gittern und einem Umlenkspiegel aufzubauen. Ebenso ist es möglich, ein Volumen-Bragg-Gitter oder ein Faser-Bragg-Gitter für den externen Pulskompressor zu verwenden.

Selbstverständlich ist es auch für den externen Pulskompressor vorgesehen und möglich, zumindest ein Polarisationsanpassungsmodul, insbesondere zwei oder mehr Polarisationsanpassungselemente, zu verwenden - so wie es oben im Zusammenhang mit dem Dispersionskompensationselement beschrieben ist.

Gemäß einer weiteren Ausführungsform ist der Ultrakurzpulsfaserlaser dadurch fortgebildet, dass die Dispersionskompensationseinheit als Dispersionskompensations- und Auskoppeleinheit ausgebildet ist und hierzu einen, insbesondere als nicht-faserbasiertes diskretes optisches Element ausgebildeten, Auskoppler umfasst. Dabei ist insbesondere vorgesehen, dass der Auskoppler ebenfalls als Polarisationsanpassungselement wirkt.

Vorteilhaft kann somit auf einen separaten Auskoppler verzichtet werden. Auch die Anzahl der notwendigen Faserspleißstellen wird geringer. Wird der Auskoppler, beispielsweise ein Strahlteiler ebenfalls als Polarisationsanpassungselement verwendet, kann ein weiteres optisches Bauteil eingespart werden.

Weitere Merkmale der Erfindung werden aus der Beschreibung erfindungsgemäßer Ausführungsformen zusammen mit den Ansprüchen und den beigefügten Zeichnungen ersichtlich. Erfindungsgemäße Ausführungsformen können einzelne Merkmale oder eine Kombination mehrerer Merkmale erfüllen.

Die Erfindung wird nachstehend ohne Beschränkung des allgemeinen Erfindungsgedankens anhand von Ausführungsbeispielen unter Bezugnahme auf die Zeichnungen beschrieben, wobei bezüglich aller im Text nicht näher erläuterten erfindungsgemäßen Einzelheiten ausdrücklich auf die Zeichnungen verwiesen wird. Es zeigen:
- FIG. 1 bis 4: jeweils einen passiv modengekoppelten Ultrakurzpulsfaserlaser in schematischer und vereinfachter Darstellung,
- FIG. 5: eine Dispersionskompensationseinheit in schematischer und vereinfachter Darstellung,
- FIG. 6: einen am Ausgang eines passiv modengekoppelten Ultrakurzpulsfaserlasers vorgesehenen externen Pulskompressor,
- FIG. 7 bis 11: weitere passiv modengekoppelte Ultrakurzpulsfaserlaser in schematischer und vereinfachter Darstellung und
- FIG 12, 13: vereinfachte schematische Darstellungen einer Dispersionskompensations- und Auskoppeleinheit.

In den Zeichnungen sind jeweils gleiche oder gleichartige Elemente und/oder Teile mit denselben Bezugsziffern versehen, so dass von einer erneuten Vorstellung jeweils abgesehen wird.

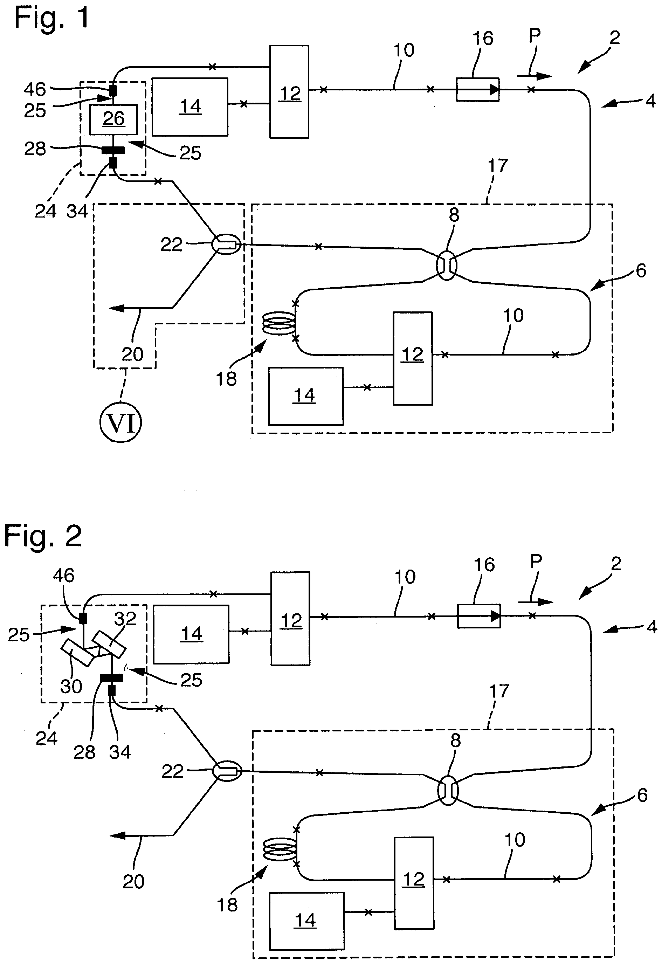

FIG. 1 zeigt in schematischer und vereinfachter Darstellung einen passiv modengekoppelten Ultrakurzpulsfaserlaser 2 mit einem Resonator in achtförmiger Konfiguration. Dieser Typ bzw. diese Konfiguration eines Faserlasers wird vielfach auch als engl.: "figure of eight arrangement" bezeichnet. Der Resonator des Ultrakurzpulsfaserlasers 2 umfasst einen Hauptring 4 und einen als nichtlineares Sagnac-Interferometer bzw. Sagnac-Schleife ausgestalteten Nebenring 6. Der Hauptring 4 und der Nebenring 6 sind über einen optischen Koppler 8 miteinander gekoppelt.

Ein über den Koppler 8 in den Nebenring 6 eintretender Laserpuls wird in zwei Teilpulse aufgespalten, wobei ein erster Teilpuls beispielsweise im Uhrzeigersinn und der zweite Teilpuls entgegen dem Uhrzeigersinn im Nebenring propagiert. Die beiden Teilpulse treffen sich am Koppler 8 wieder und interferieren miteinander. Durch Einstellen des Phasenunterschieds zwischen den beiden Teilpulsen ist die Effizienz der Auskopplung über die Interferenz zwischen den beiden Teilpulsen einstellbar.

In dem Hauptring 4 und in dem Nebenring 6 befindet sich jeweils ein aktiver Faserabschnitt 10, in dem das Material der Lichtleitfaser als laseraktives Medium ausgebildet ist. Nach Durchlaufen des Signals durch den Laserverstärker weist das Signal am Ausgang eine erhöhte Leistung auf. Das Fasermaterial des aktiven Faserabschnitts 10 ist dotiert. Als Dotierelemente kommen seltene Erden in Betracht, insbesondere Ytterbium (Yb), Erbium (Er), Neodymium (Nd), Thulium (Tm), Holmium (Ho) oder Praseodym (Pr). Die Wahl des geeigneten Dotierelements hängt von der gewünschten Grundwellenlänge des Ultrakurzpulsfaserlasers 2 ab.

In den Hauptring 4 und in den Nebenring 6 ist ferner jeweils ein Wellenlängenmultiplexer 12 integriert. Die Wellenlängenmultiplexer 12 dienen jeweils zum Einkoppeln von Pumplicht in den aktiven Faserabschnitt 10. Zu diesem Zweck ist mit den Wellenlängenmultiplexern 12 jeweils eine Pumplichtquelle 14 gekoppelt. Bei der Pumplichtquelle 14 handelt es sich beispielsweise um eine Laserdiodenquelle oder eine andere geeignete Pumplichtquelle.

In den Hauptring 4 ist ferner ein optischer Isolator 16 integriert, welcher sicherstellt, dass in dem Hauptring 4 die mit einem Pfeil angedeutete Propagationsrichtung P der Lichtpulse eingehalten wird. Alternativ zu dem optischen Isolator 16 ist ein optischer Zirkulator vorgesehen, wobei auf die zugehörigen Ausführungsbeispiele später eingegangen wird.

In den Nebenring 6 ist ferner eine passive Lichtleitfaser 18 integriert. Die in dem Ultrakurzpulsfaserlaser 2 erzeugten Laserpulse werden an einem Ausgang 20 ausgekoppelt, der über einen Ausgangskoppler 22 mit dem Hauptring 4 gekoppelt ist.

In dem in FIG. 1 dargestellten Ausführungsbeispiel befindet sich ein aktiver Faserabschnitt 10 sowohl in dem Hauptring 4 als auch in dem Nebenring 6. Entsprechend handelt es sich bei dem Nebenring 6, der als nichtlineares Sagnac-Interferometer ausgestaltet ist, um einen sog. NALM (engl.: nonlinear amplifying loop mirror). Gemäß weiterer nicht dargestellter Ausführungsbeispiele befindet sich ein aktiver Faserabschnitt 10 und entsprechend auch der zugehörige Wellenlängenmultiplexer 12 sowie die damit verbundene Pumplichtquelle 14 lediglich in einem der beiden Faserringe, d.h. entweder in dem Hauptring 4 oder in dem Nebenring 6. Die Lichtleitfasern, aus denen der Ultrakurzpulsfaserlaser 2 aufgebaut ist, sind sämtlich polarisationserhaltende oder polarisierende Fasern, insbesondere polarisationserhaltende single-mode Lichtleitfasern.

Die Faserverbindung zwischen der Pumplichtquelle 14 und dem Wellenlängenmultiplexer 12 kann nicht-polarisationserhaltend oder polarisationserhaltend sein.

Als "polarisationserhaltend" werden die verwendeten Lichtleitfasern dann angesehen, wenn sie in Bezug auf das Lasersignal des Ultrakurzpulsfaserlasers 2 eine polarisationserhaltende Wirkung haben.

Der Ultrakurzpulsfaserlaser 2 arbeitet beispielsweise bei einer Repetitionsfrequenz von 20 MHz und einer mittleren Laserwellenlänge im Bereich zwischen 1000 nm und 1100 nm.

Der Ultrakurzpulsfaserlaser 2 weist eine Dispersionskompensationseinheit 24 auf. Diese ist im Resonator des Ultrakurzpulsfaserlasers 2 angeordnet, bzw. in den Resonator integriert. Die Dispersionskompensationseinheit 24 umfasst ein Dispersionskompensationselement 26. Ferner ist ein erstes Polarisationsanpassungselement 28 vorgesehen, das zum Anpassen eines Polarisationszustandes von in der Faser propagierenden Laserpulsen an das optische Dispersionskompensationselement 26 vorgesehen ist.

Das Polarisationsanpassungselement 28 ist in Propagationsrichtung P vor dem Dispersionskompensationselement 24 angeordnet, da das Dispersionskompensationselement 24 polarisationsunabhängige Eigenschaften aufweist. Gemäß der Erfindung ist das Polarisationsanpassungselement nach dem Dispersionskompensationselement angeordnet. Im allgemeineren Fall sind zwei Polarisationsanpassungsmodule vorgesehen, vor und hinter dem Dispersionskompensationselement 24. Dies gilt für alle Ausführungsbeispiele.

FIG. 2 zeigt einen weiteren Ultrakurzpulsfaserlaser 2. Mit identischen Bezugszeichen versehene Elemente dieses Ultrakurzpulsfaserlasers 2 sind identisch zu denjenigen Elementen des bereits im Zusammenhang mit FIG. 1 erläuterten Ultrakurzpulsfaserlasers 2 ausgestaltet. Aus diesem Grund wird auf wiederholte Erläuterungen verzichtet.

Die Dispersionskompensationseinheit 24 umfasst als Dispersionskompensationselement 26 einen ersten gechirpten Spiegel 30 und einen zweiten gechirpten Spiegel 32. Der erste und der zweite gechirpte Spiegel 30, 32 sind bevorzugt plan-parallel zueinander angeordnet. So ist es möglich, dass die in dem Ultrakurzpulsfaserlaser 2 erzeugten Laserpulse mehrere Durchläufe in dem Dispersionskompensationselement 26 ausführen, d.h. mehrfach von dem ersten und zweiten gechirpten Spiegel 30, 32 reflektiert werden. Ferner ist ein erstes Polarisationsanpassungselement 28 zur Anpassung der Polarisationszustände in den Fasern und dem Dispersionskompensationselement 26 vorgesehen. Des erste Polarisationsanpassungselement 28 ist zwischen einem ersten Ende 34 der Lichtleitfaser und dem Dispersionskompensationselement 26 angeordnet, gemäß dem dargestellten Ausführungsbeispiel der Anordnung aus den beiden planparallel orientierten gechirpten Spiegeln 30, 32.

Ebenso wie bei dem in FIG. 1 dargestellten Ausführungsbeispiel ist das Polarisationsanpassungselement 28 in Propagationsrichtung P vor dem Dispersionskompensationselement 24 angeordnet, da das Dispersionskompensationselement 24 polarisationsunabhängige Eigenschaften aufweist. Auch hier ist eine Anordnung hinter oder zu beiden Seiten des Dispersionskompensationselements 24 vorgesehen.

Die gechirpten Spiegel 30, 32 sind dielektrische Spiegel mit variabler Bragg-Struktur. Sie sind vorteilhaft stabil und kostengünstig und stehen somit als Elemente zur Dispersionskompensation der propagierenden Laserpulse zur Verfügung. Dielektrische Spiegel mit variabler Bragg-Struktur sind Mehrfachschichtsysteme (engl. multilayer), bei denen abwechselnd Schichten mit stark unterschiedlichen optischen Brechungsindizes übereinander angeordnet sind. Durch Variation der Doppelschichtdicke, d.h. der Summe der Schichtdicke der beiden unterschiedlichen Materialien, wird erreicht, dass Anteile des Laserpulses mit unterschiedlicher Wellenlänge in unterschiedlicher Tiefe des Schichtpakets reflektiert werden. Auf diese Weise erfolgt eine Kompensation der Dispersion. Als Materialsystem ist beispielsweise Siliziumoxid/Hafniumoxid geeignet.

Der erste und zweite gechirpte Spiegel 30, 32 sind insbesondere hoch dispersive gechirpte Spiegel 30, 32. Im Kontext der vorliegenden Beschreibung soll unter einem hoch dispersiven gechirpten Spiegel ein solcher Spiegel verstanden werden, welcher dazu eingerichtet ist, eine Gruppenlaufzeitdispersion (engl.: group delay dispersion) im Absolutbetrag von mindestens 1.000 fs² zu kompensieren. Es ist ebenso möglich, einen oder beide gechirpten Spiegel 30, 32 durch einen regulären d.h. nicht-dispersiven Spiegel zu ersetzen.

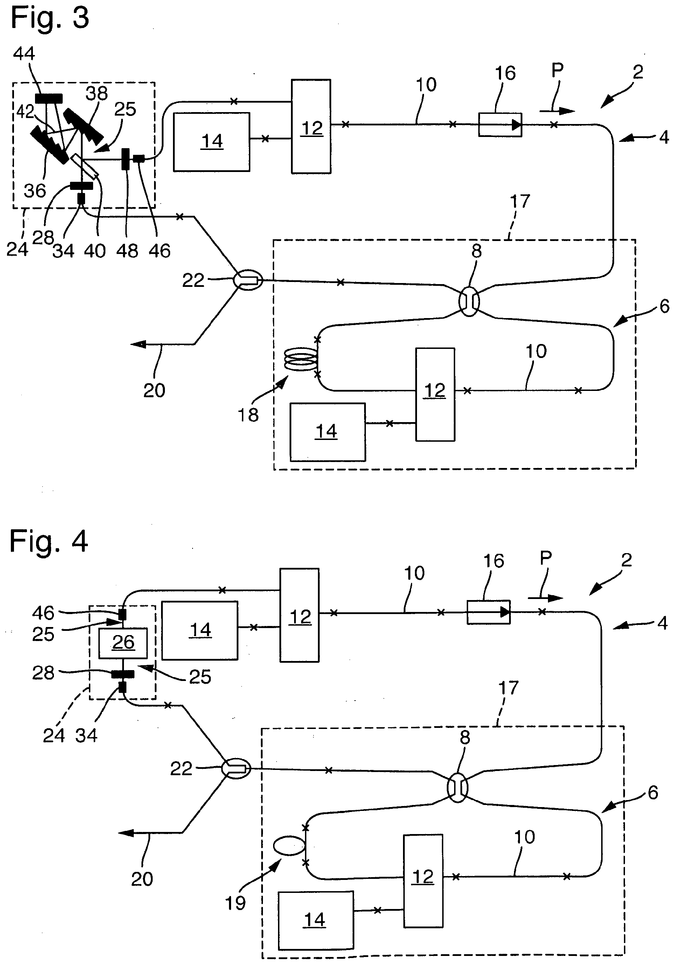

FIG. 3 zeigt einen weiteren Ultrakurzpulsfaserlaser 2. Abgesehen von der Dispersionskompensationseinheit 24 ist dieser identisch zu den in den FIG. 1 und 2 gezeigten Ultrakurzpulsfaserlasern 2 aufgebaut. Aus diesem Grund wird auf eine erneute Vorstellung der bekannten Bauteile, welche mit identischen Bezugszeichen sind, verzichtet.

Die Dispersionskompensationseinheit 24 umfasst als Dispersionskompensationselement 26 gemäß dem dargestellten Ausführungsbeispiel ein erstes optisches Gitter 36 und ein zweites optisches Gitter 38. Das erste und das zweite optische Gitter 36, 38 sind bevorzugt plan-parallel zueinander angeordnet. Am Eingang der Dispersionskompensationseinheit 24 befindet sich außerdem ein erstes Polarisationsanpassungselement 28. Dieses ist zwischen dem ersten Ende 34 der Lichtleitfaser und dem Dispersionskompensationselement 26 angeordnet. Der an dem ersten Ende 34 austretende Laserpuls wird seiner Polarisation nach durch das erste Polarisationsanpassungselement 28 an das Dispersionskompensationselement 26, im dargestellten Fall an das erste und zweite optische Gitter 36, 38, angepasst. Nachdem der Laserpuls das erste Polarisationsanpassungselement 28 durchlaufen hat, trifft er auf das zweite optische Gitter 38. Das zweite optische Gitter 38 bedingt eine spektrale Auffächerung des Laserpulses, dargestellt durch das geweitete Strahlenbündel 42. Nach anschließender Reflektion an dem ersten optischen Gitter 36 trifft das geweitete Strahlenbündel 42 auf einen Umkehrspiegel 44, von dem es zurück reflektiert wird. Alternativ zu einem Umkehrspiegel 44 ist ein Umkehrprisma oder ein verkippter Spiegel vorgesehen.

Aufgrund der geometrisch bedingten Laufzeitunterschiede der einzelnen spektralen Komponenten in dem aufgefächerten Strahlenbündel 42 tritt eine Dispersionskompensation ein. Der derart dispersionskompensierte Laserpuls wird, sobald er erneut an dem zweiten optischen Gitter 38 reflektiert wurde, von dem Spiegel 40 in Richtung eines zweiten Endes 46 der Lichtleitfaser reflektiert. Zur Anpassung der Polarisation an die Lichtleitfaser durchläuft der Laserpuls ein zweites Polarisationsanpassungselement 48. Dieses ist am Ausgang der Dispersionskompensationseinheit 24 angeordnet, zwischen dem zweiten Ende 46 der Lichtleitfaser und dem Dispersionskompensationselement 28. Mit anderen Worten umfasst das Dispersionskompensationselement 26 in dem in FIG. 3 dargestellten Ausführungsbeispiel, den Spiegel 40, das erste und zweite optische Gitter 36, 38 sowie den Umkehrspiegel 44. Wenn die Gitter polarisationsunabhängig sind kann auf eines oder beide der Polarisationsanpassungselemente 28, 48 verzichtet werden.

Die zum Aufbau des Ultrakurzpulsfaserlasers 2 verwendeten Lichtleitfasern sind polarisationserhaltende oder polarisierende Lichtleitfasern, so dass die Laserpulse im Resonator des Ultrakurzpulsfaserlasers 2 als linear polarisierte Pulse propagieren. Das erste und das zweite Polarisationsanpassungselement 28, 48 dienen der Anpassung der Polarisation von in dem Resonator propagierenden, beispielsweise linear polarisierten Laserpulsen an die Polarisationsart oder -richtung des Dispersionskompensationselementes 26. Das zweite Polarisationsanpassungselement 48 dient der erneuten Anpassung der Polarisation, beispielsweise der Polarisationsebene, des das Dispersionskompensationselement 26 verlassenen Laserpulses an die Polarisationsart oder -ebene, in der die Laserpulse innerhalb des Resonators, d.h. in der Lichtleitfaser, propagieren. Wenn das Dispersionskompensationselement 26 polarisationsunabhängig ist, kann auf eines oder beide der Polarisationsanpassungselemente 28 oder 48 verzichtet werden.

FIG. 4 zeigt einen weiteren Ultrakurzpulsfaserlaser 2, der identisch zu dem in FIG. 1 schematisch und vereinfacht dargestellten Ultrakurzpulsfaserlaser 2 aufgebaut ist. Abgesehen von der Tatsache, dass die passive Lichtleitfaser 18 eine hoch-nichtlineare passive polarisationserhaltende oder polarisierende Lichtleitfaser 19 ist.

Im Kontext der vorliegenden Beschreibung wird als hoch-nichtlineare Lichtleitfaser eine Faser mit einem Fasernichtlinearitätsfaktor γ = ω0/c0 n2/Aeff, von größer als drei, insbesondere größer als fünf, ferner insbesondere größer als sieben weiterhin insbesondere größer als acht und ferner insbesondere größer als zehn und weiterhin insbesondere größer als 13 angesehen. Alle Werte in 1/(km x W.)

Auch diese hoch-nichtlineare Lichtleitfaser ist polarisationserhaltend. In der zuvor genannten Formel ist ω0 die Winkelfrequenz des Laserlichts c0 die Lichtgeschwindigkeit im Freiraum, n2 der nichtlineare Brechungsindexkoeffizient bzgl. der Intensität (n = n0 + n2 x I mit I der Intensität des Lichts) und Aeff der effektive Modenfläche der Lichtleitfaser (mit Aeff = π x (MFD/2)² mit MFD dem Durchmesser des Modenfeldes im Faserwellenleiter (engl. mode field diameter).

Entscheidend für die Funktionalität des Ultrakurzpulsfaserlasers 2 ist das Produkt aus γ*L, wobei L die Länge der passiven Lichtleitfaser 18 ist. Im Vergleich zu herkömmlichen nichtlinearen Lichtleitfasern, deren Wert γ zwischen eins und fünf liegt, führt die Verwendung einer hoch-nichtlinearen passiven Lichtleitfaser 18 zu einer Verkürzung der benötigten Faserlänge. Vorteilhaft ist es beispielsweise möglich, anstatt einer 15 m langen passiven Lichtleitfaser 18 eine nur 1,5 m lange passive Lichtleitfaser 18 vorzusehen. Dies verkürzt die Laufzeiten der Laserpulse in dem Resonator des Ultrakurzpulsfaserlasers 2. Höhere Repetitionsfrequenzen werden möglich. Beispielsweise liefert der Ultrakurzpulsfaserlaser gemäß dem dargestellten Ausführungsbeispiel eine Pulswiederholrate von 20 MHz und mehr, anstatt der sonst möglichen Repetitionsfrequenz im Bereich von 10 MHz. Außerdem sind aufgrund der geringeren Pulswiederholungsrate die Rauscheigenschaften des Lasers geringer.

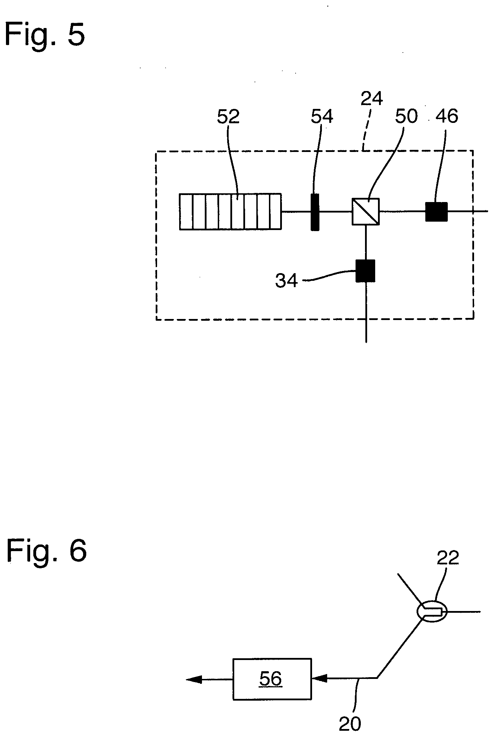

FIG. 5 zeigt eine Dispersionskompensationseinheit 24, welche in einem Ultrakurzpulsfaserlaser 2 gemäß einem weiteren Ausführungsbeispiel integriert wird. Beispielsweise wird die in FIG. 1 gezeigte Dispersionskompensationseinheit 24 durch die in FIG. 5 gezeigte Dispersionskompensationseinheit 24 ersetzt. Die in FIG. 5 schematisch und vereinfacht gezeigte Dispersionskompensationseinheit 24 umfasst als Dispersionskompensationselement 26 ein Volumen-Bragg-Gitter. Ein am ersten Ende 34 aus der Lichtleitfaser austretender Laserpuls durchläuft zunächst den Strahlteiler 50 und wird in Richtung des Volumen-Bragg-Gitters abgelenkt. Zuvor durchläuft der Laserpuls eine λ/4-Platte 54, ehe er nach Reflektion an dem Volumen-Bragg-Gitter 52 erneut durchläuft. λ/4-Platte erfüllt somit gleichzeitig die Funktion des ersten und zweiten Polarisationsanpassungselements 28, 48. Der linear polarisierte Laserpuls wird durch die λ/4-Platte 54 in einen zirkular polarisierten Laserpuls umgewandelt, von dem Volumen-Bragg-Gitter 52 reflektiert, wobei die Dispersion des Laserpulses kompensiert wird. Anschließend wird der zirkular polarisierte Laserpuls von der λ/4-Platte 54 erneut in linear polarisiertes Licht umgewandelt und durchläuft den Strahlteiler 50 in Richtung des zweiten Endes 46 der Lichtleitfaser.

Gemäß einem weiteren Ausführungsbeispiel umfasst der Ultrakurzpulsfaserlaser 2 einen externen Pulskompressor 56. Zu diesem Zweck wird beispielsweise der in Fig. 1 mit VI bezeichnete Abschnitt des Ultrakurzpulsfaserlasers 2 durch die in FIG. 6 gezeigte Konfiguration ersetzt. Der den Ausgang 20 verlassende Laserpuls tritt in den externen Pulskompressor 56 ein und verlässt diesen an dessen Ausgang. Der externe Pulskompressor 56 ist bevorzugt ähnlich zu der Dispersionskompensationseinheit 24 aufgebaut. Dies betrifft sämtliche Ausführungsbeispiele.

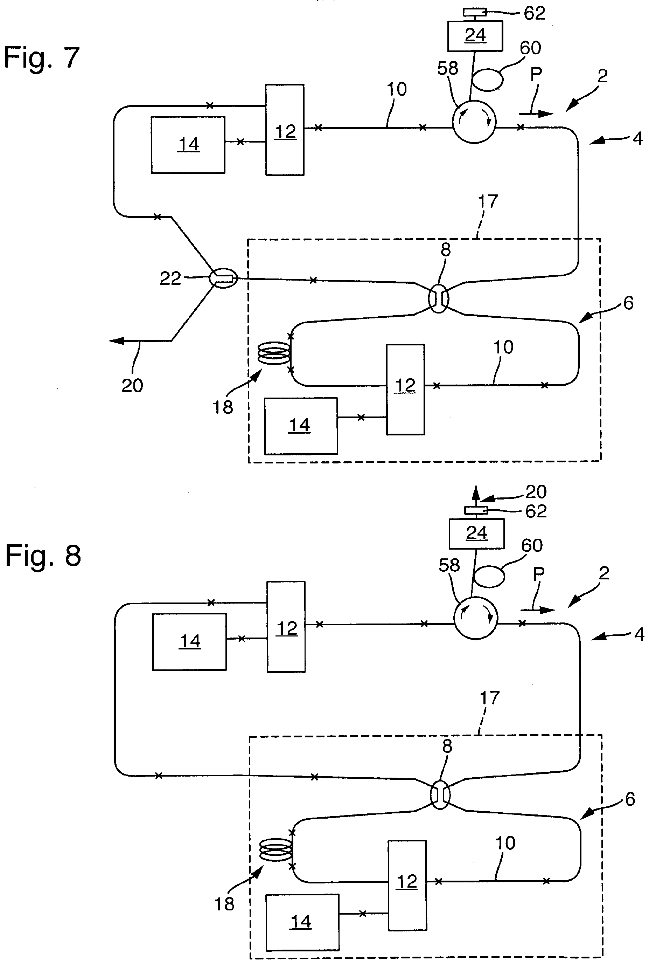

FIG. 7 zeigt einen weiteren Ultrakurzpulsfaserlaser 2 in vereinfachter schematischer Darstellung. Der Ultrakurzpulsfaserlaser 2 ist ähnlich zu dem in FIG. 1 dargestellten Ultrakurzpulsfaserlaser 2 aufgebaut. Anstatt des in FIG. 1 dargestellten optischen Isolators umfasst der in FIG. 7 dargestellte Aufbau jedoch einen optischen Zirkulator 58, einen daran gekoppelten Verzögerungs-Faserabschnitt 60 und einen Umkehrspiegel 62.

Der optische Zirkulator 58 weist einen ersten bis dritten Anschluss auf. Der Zirkulator 58 ist derart in den Hauptring 4 integriert, dass in dem Hauptring 4 in Propagationsrichtung P propagierende Laserpulse am ersten Anschluss in den Zirkulator 58 eingekoppelt und von dem Zirkulator 58 an den zweiten Anschluss weitergeleitet werden. An diesen zweiten Anschluss des Zirkulators 58 ist der Verzögerungs-Faserabschnitt 60 angekoppelt. Der Verzögerungs-Faserabschnitt 60 bildet ebenfalls einen Teil des Hauptrings 4. An seinem dem Zirkulator 58 abgewandten Ende des Verzögerungs-Faserabschnitts 60 ist ein Umlenkspiegel 62 vorhanden. Auch die Dispersionskompensationseinheit 24 befindet sich an diesem Ende. Sie ist so wie in den zuvor genannten Ausführungsbeispielen erwähnt ausgestaltet.

Der Umkehrspiegel 62 reflektiert Laserpulse, welche den Verzögerungs-Faserabschnitt 60 durchlaufen haben zurück in den Verzögerungs-Faserabschnitt 60, so dass eine Doppelpasskonfiguration bereitgestellt wird. Im Ergebnis wird der Verzögerungs-Faserabschnitt 60 also doppelt durchlaufen - seine Länge wird als optische Wegstrecke doppelt genutzt.

Als Umkehrspiegel 62 ist sowohl ein separates optisches Element, beispielsweise ein Spiegel, als auch ein faserbasiertes Element vorgesehen, beispielsweise ein Faser-Bragg-Gitter. Aufgrund der großen optischen Weglänge im Hauptring 4 ist der dargestellte Ultrakurzpulsfaserlaser 2 für besonders niedrige Pulswiederholraten ausgelegt.

FIG. 8 zeigt in schematischer vereinfachter Darstellung einen weiteren Ultrakurzpulsfaserlaser 2, der sich im Vergleich zu dem in FIG. 7 dargestellten Ultrakurzpulsfaserlaser 2 lediglich darin unterscheidet, dass der Umkehrspiegel 62 gleichzeitig als Auskoppelspiegel zur Auskopplung der erzeugten Laserpulse dient. Vorteilhaft ist es somit möglich, auf den Auskoppler 22 (vgl. Fig. 7) zu verzichten.

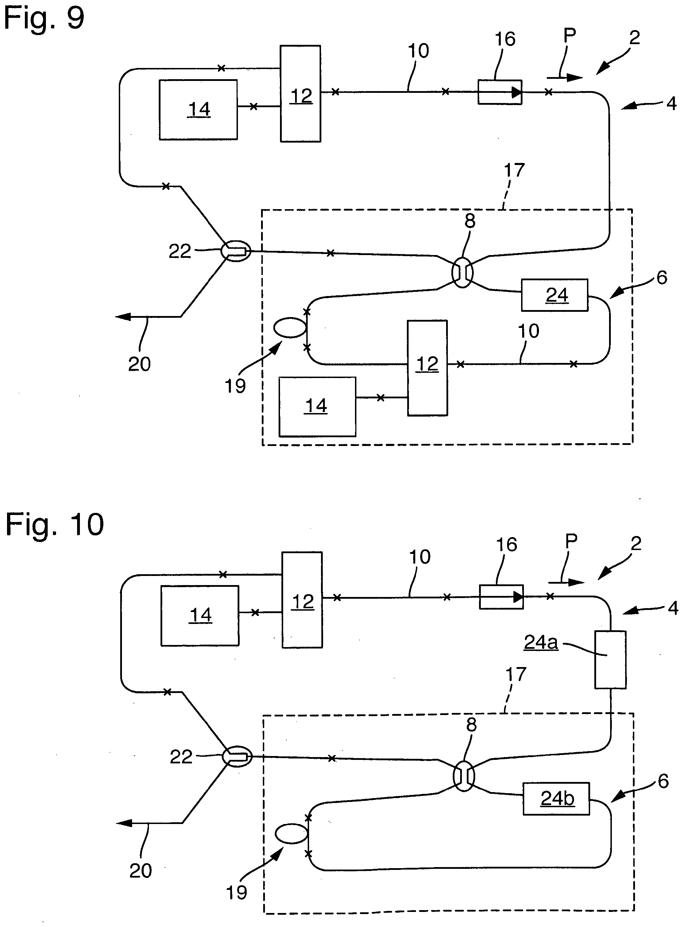

FIG. 9 zeigt einen weiteren Ultrakurzpulsfaserlaser 2, der ähnlich dem in FIG. 4 dargestellten Ultrakurzpulsfaserlaser 2 ausgestaltet ist. Im Unterschied zu der in FIG. 4 dargestellten Konfiguration befindet sich die Dispersionskompensationseinheit 24 jedoch nicht im Hauptring 4, sondern im Nebenring 6.

Insbesondere ist die Dispersionskompensationseinheit 24 direkt hinter dem Koppler 8 angeordnet. Es wird eine asymmetrische Anordnung in der nichtlinearen Sagnac-Schleife (Nebenring 6) bereitgestellt. Bei einer solchen asymmetrischen Anordnung der Dispersionskompensationseinheit 24 direkt hinter dem Koppler 8 sind die in den Nebenringen 6 eingekoppelten Laserpulse bevorzugt gechirpt oder gestreckt. Der weit überwiegende Teil des aufgeprägten Chirps wird von der Dispersionskompensationseinheit 24 kompensiert, so dass nach dem Durchlauf der Dispersionskompensationseinheit 24 ein Laserpuls mit höherer Pulsspitzenleistung vorliegt. Der komprimierte Laserpuls ruft in dem hoch-nichtlinearen Faserabschnitt 19 vergleichbare nichtlineare Effekte hervor, wie dies ein verstärkter nicht-komprimierter Laserpuls, tun würde.

Dieser Effekt wird von dem in FIG. 10 dargestellten Ausführungsbeispiel, welches erneut in schematischer vereinfachter Darstellung einen Ultrakurzpulsfaserlaser 2 zeigt, noch konsequenter ausgenutzt. In dem Hauptring 4 als auch in dem Nebenring 6 ist jeweils eine Dispersionskompensationseinheit 24a, 24b vorgesehen. Die in dem Hauptring 4 zirkulierenden Laserpulse werden von der ersten Dispersionskompensationseinheit 24a mit einem Chirp versehen, welcher in der zweiten Dispersionskompensationseinheit 24b kompensiert wird. Aufgrund der stattfindenden Erhöhung der Pulsspitzenleistung erfolgt in dem hoch-nichtlinearen Faserabschnitt 19 ein erhöhter nichtlinearer Effekt, beispielsweise im Hinblick auf die Selbst-Phasenmodulation. Die asymmetrische Anordnung der Dispersionskompensationseinheit 24b hat den Vorteil, dass die akkumulierte nichtlineare Phase in beiden Umlaufrichtungen unterschiedlicher wird. Dieser Effekt ist für die Funktion eines nichtlinearen Sagnac-Interferometers essentiell, so dass es möglich wird, auf den Einsatz eines Faserverstärkers im Nebenring 6 gänzlich zu verzichten. Dies senkt die Herstellungskosten des Ultrakurzpulsfaserlasers 2 erheblich.

Alternativ zu der hoch-nichtlinearen Faser 19 in den FIG. 9 und 10 ist es möglich, so wie in den Ausführungsbeispielen der FIG. 1 bis 3 sowie FIG. 7 und 8, eine nichtlineare Faser 18 mit geringerer Nichtlinearität einzusetzen.

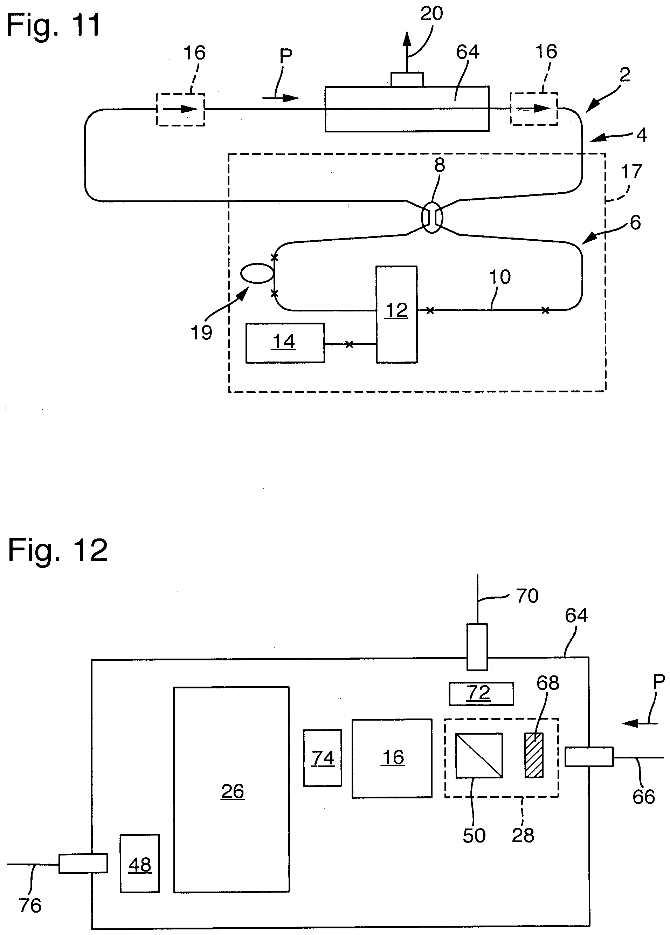

Fig. 11 zeigt in schematisch vereinfachter Darstellung einen Ultrakurzpulsfaserlaser 2, dessen Resonator einen Hauptring 4 und einen als nicht-lineares Sagnac-Interferometer ausgestalteten Nebenring 6 umfasst. Der Hauptring 4 und der Nebenring 6 sind über einen optischen Koppler 8 miteinander gekoppelt. Im Nebenring 6 befindet sich ein aktiver Faserabschnitt 10 sowie ein Wellenlängenmultiplexer 12, der zur Einkopplung eines von der Pumplichtquelle 14 bereitgestellten Pumpsignals dient. Außerdem ist eine nichtlineare Lichtleitfaser 19 in den Nebenring 6 integriert. Der Nebenring 6 bildet gemeinsam mit dem optischen Koppler 8 einen sogenannten NALM (engl.: nonlinear amplifying loop mirror) aus.

Im Hauptring 4 ist eine Propagationsrichtung P der Lichtpulse beispielhaft eingezeichnet. Um sicherzustellen, dass im Hauptring 4 die Propagationsrichtung P eingehalten wird, ist ein optischer Isolator 16 vorgesehen, der alternativ an den beiden dargestellten Positionen in den Hauptring 4 oder als diskretes optisches Element in eine Dispersionskompensations- und Auskoppeleinheit 64 integriert werden kann.

Im Gegensatz zu den zuvor erwähnten Ausführungsbeispielen umfasst das in Fig. 11 gezeigte Ausführungsbeispiel eine solche Dispersionskompensations- und Auskoppeleinheit 64. Diese kombiniert die Funktion der Dispersionskompensationseinheit 24 mit derjenigen des Auskopplers 22 (vgl. beispielsweise Figuren 1 bis 4). Entsprechend stellt die Dispersionskompensations- und Auskoppeleinheit 64 einen Ausgang 20 für das mit dem Ultrakurzpulsfaserlaser 2 erzeugte Laserlicht bereit.

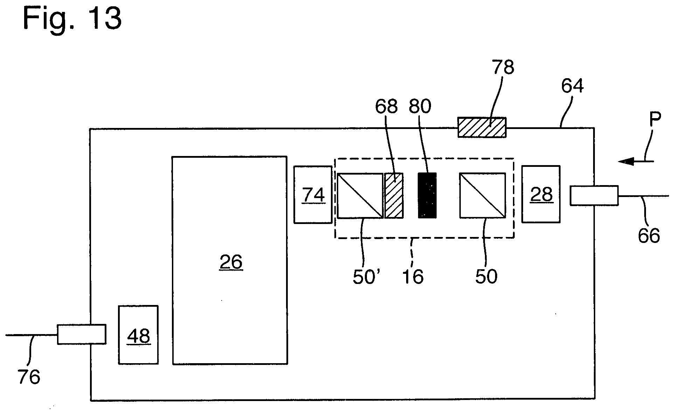

Eine Dispersionskompensations- und Auskoppeleinheit 64 gemäß verschiedener Ausführungsbeispiele ist in den Figuren 12 und 13 gezeigt.

Der in Propagationsrichtung P der polarisationserhaltenden Lichtleitfaser am Eingang, auch als Eingangsfaser 66 bezeichnet, in die in Fig. 12 dargestellte Einheit eintretende Laserpuls trifft zuerst auf ein erstes Polarisationsanpassungselement 28. Dieses umfasst eine λ/2-Platte 68, welche die Funktion hat, die Polarisationsebene des aus der Faser austretenden Laserpulses in eine gewünschte Richtung einzustellen. Die Funktion der λ/2-Platte 68 entspricht einer Rotation der Eingangsfaser 66 um die eigene Achse. Das erste Polarisationsanpassungselement 28 umfasst außerdem einen als Polarisator wirkenden Strahlteiler 50, mit welchem ein Bruchteil der eintretenden Laserstrahlung in Richtung der Ausgangsfaser 70 abgelenkt wird. Zur Anpassung der Polarisation des ausgekoppelten Laserpulses an die Ausgangsfaser 70 ist ein weiteres Polarisationsanpassungselement (beispielhaft drittes Polarisationsanpassungselement 72) vorgesehen. Dieses ist optional. Die Funktion des Polarisationsanpassungselements 72 entspricht einer Rotation der Ausgangsfaser 70 um die eigene Achse.

Anstatt der Ausgangsfaser 70 kann gemäß einem weiteren nicht dargestellten Ausführungsbeispiel ein Austrittsfenster vorgesehen sein, durch welches die Laserstrahlung ausgekoppelt wird.

Auf das erste Polarisationsanpassungselement 28 in Propagationsrichtung P folgend umfasst die Dispersionskompensations- und Auskoppeleinheit 64 einen optischen Isolator 16. Der optische Isolator 16 ist optional innerhalb der Dispersionskompensations- und Auskoppeleinheit 64 angeordnet. Wie Fig. 11 zeigt, kann ein optischer Isolator 16 ebenfalls in Propagationsrichtung P vor oder hinter dieser Einheit 64 angeordnet sein. In einem solchen Fall handelt es sich dann jedoch um einen faserbasierten Isolator und nicht um ein diskretes optisches Bauteil. Mit anderen Worten ist also der optische Isolator 16 innerhalb der Dispersionskompensations- und Auskoppeleinheit 64 optional vorgesehen. Diese umfasst ferner ein weiteres Polarisationsanpassungselement, beispielhaft ein viertes Polarisationsanpassungselement 74. Das Polarisationsanpassungselement 74 ist optional. Seine Notwendigkeit hängt von der Wahl des dispersiven Elements in dem Dispersionskompensationselement 26 ab. Der in der Propagationsrichtung P propagierende Laserpuls trifft anschließend auf das Dispersionskompensationselement 26, welches gemäß einem der zuvor genannten Ausführungsbeispiele ausgestaltet ist. Bevor der Laserpuls am Ausgang der Dispersionskompensations- und Auskoppeleinheit 64 in die Ausgangsfaser 76 eintritt, durchläuft er das zweite Polarisationsanpassungselement 48, welches ebenso wie das erste Polarisationsanpassungselement 28 aus den vorhergehenden Ausführungsbeispielen bereits bekannt ist. Die Funktion des zweiten Polarisationsanpassungselements 48 entspricht einer Rotation der Ausgangsfaser 76 um die eigene Achse.

Der gezeigte Aufbau hat den Vorteil, dass auf den Faserauskoppler 22 als auch auf den faserintegrierten Isolator 16 verzichtet werden kann. Damit sind erstens weniger Faserspleißpunkte im Resonator notwendig, was die Herstellung vereinfacht, und zweitens wird weniger Faser im Resonator verwendet, was den Laser 2 insgesamt kompakter macht und höhere Pulswiederholungsraten ermöglicht. Ferner ist in der Dispersionskompensationseinheit 26 eine geringere Kompensation der Dispersion notwendig, was auch diese Einheit kompakter macht.

Die Reihenfolge der gezeigten Elemente kann variiert werden. Beispielsweise kann die Reihenfolge von Isolator 16 und Dispersionskompensationselement 26 vertauscht werden. Auch könnte der als Auskoppler wirkende Strahlteiler 50 erst am Ende der Dispersionskompensations- und Auskoppeleinheit 64 angeordnet werden. Wie bereits erwähnt, kann anstatt der Ausgangsfaser 70 ein Auskoppelfenster, insbesondere ein optisch antireflektionsbeschichtetes Glas eingesetzt werden (Freistrahlauskopplung).

Die Dispersionskompensations- und Auskoppeleinheit 64 in Fig. 13 ist für die Freistrahl-Auskopplung aufgebaut und umfasst dementsprechend ein Auskoppelfenster 78. Der Auskoppler ist in diesem Ausführungsbeispiel mit dem optischen Isolator gekoppelt, ist gewissermaßen "verschmolzen" worden". Ein Isolator besteht typischerweise aus zwei Polarisatoren bzw. Strahlteilern 50, 50', von denen der erste Strahlteiler 50 direkt zur Auskopplung des Laserstrahls verwendet werden kann. Ferner umfasst ist ein Faraday-Rotator 80 sowie die bereits aus Fig. 12 bekannte Kombination aus λ/2-Platte 68 und dem zweiten Strahlteiler 50. Die Funktion der λ/2-Platte entspricht einer Rotation des polarisierenden Strahlteilers 50 um die optische Achse, d.h. der Strahlrichtung bei senkrechtem Einfall auf das Element. Die übrigen mit identischen Bezugszeichen versehenen Elemente sind aus Fig. 12 bekannt.

Wie bereits erwähnt, entspricht die Funktion der Polarisationsanpassungselemente am Eingang und Ausgang der Dispersionskompensations- und Auskoppeleinheit 64 einer Rotation der Eingangsfaser 66 bzw. der Ausgangsfaser 76. Der optische Isolator 16 kann wahlweise innerhalb oder außerhalt der Dispersionskompensations- und Auskoppeleinheit 64 angeordnet werden. Ebenso kann alternativ eine Freistrahlauskopplung oder eine Auskopplung in eine Ausgangsfaser 70 erfolgen. Soll auf entsprechende Polarisationsanpassungselemente verzichtet werden, so müsste die Eingangs- bzw. Ausgangsfaser 66, 76 entsprechend in justierter Position in oder an der Dispersionskompensations- und Auskoppeleinheit 64 fixiert werden. Auch dies ist gemäß weiterer Ausführungsbeispiele vorgesehen.

### Bezugszeichenliste

- 2: Ultrakurzpulsfaserlaser
- 4: Hauptring
- 6: Nebenring
- 8: optischer Koppler
- 10: aktiver Faserabschnitt
- 12: Wellenlängenmultiplexer
- 14: Pumplichtquelle
- 16: optischer Isolator
- 17: NALM
- 18: passive Lichtleitfaser
- 19: hoch-nichtlineare Lichtleitfaser
- 20: Ausgang
- 22: Auskoppler
- 24, 24a, 24b: Dispersionskompensationseinheit
- 26: Dispersionskompensationselement
- 25: Freistrahlstrecke
- 28: erstes Polarisationsanpassungselement
- 30: erster gechirpter Spiegel
- 32: zweiter gechirpter Spiegel
- 34: erstes Ende
- 36: erstes optisches Gitter
- 38: zweites optisches Gitter
- 40: Spiegel
- 42: Strahlenbündel
- 44: Umkehrspiegel
- 46: zweites Ende
- 48: zweites Polarisationsanpassungselement
- 50, 50': Stahlteiler
- 52: Volumen-Bragg-Gitter
- 54: λ/4-Platte
- 56: externer Pulskompressor
- 58: Zirkulator
- 60: Verzögerungs-Faserabschnitt
- 62: Umkehrspiegel
- 64: Dispersionskompensations- und Auskoppeleinheit
- 66: Eingangsfaser
- 68: λ/2-Platte
- 70: Ausgangsfaser
- 72: drittes Polarisationsanpassungselement
- 74: viertes Polarisationsanpassungselement
- 76: Ausgangsfaser
- 78: Auskoppelfenster
- 80: Faraday-Rotator

- P: Propagationsrichtung

## Patentansprüche

1. Passiv modengekoppelter Ultrakurzpulsfaserlaser (2) zum Erzeugen ultrakurzer Laserpulse, umfassend einen Resonator in achtförmiger Konfiguration, wobei der Resonator einen Hauptring (4) und einen an diesen optisch gekoppelten, als nichtlineares Sagnac-Interferometer ausgestalteten Nebenring (6) aufweist, und wobei der Hauptring (4) und der Nebenring (6) aus polarisationserhaltenden Lichtleitfasern aufgebaut sind und der Hauptring (4) und/oder der Nebenring (6) einen als laseraktives Medium ausgebildeten Faserabschnitt (10) aufweisen, wobei das laseraktive Medium optisch durch eine außerdem umfasste, extern-gekoppelte Pumplichtquelle (14) gepumpt wird, wobei im Resonator zumindest eine Dispersionskompensationseinheit (24) zur Kompensation einer Gruppenlaufzeitdispersion der ultrakurzen Laserpulse vorhanden ist, wobei die Dispersionskompensationseinheit (24) eine separate optische Einheit ist und wobei die Dispersionskompensationseinheit (24) zumindest ein Dispersionskompensationselement (26) umfasst und an einem Eingang und/oder einem Ausgang der Dispersionskompensationseinheit (24) zwischen einem ersten Ende (34) und/oder einem zweiten Ende (46) der Lichtleitfaser des Hauptrings (4) und/oder des Nebenrings (6) und dem Dispersionskompensationselement (26) eine Freistrahlstrecke (25) vorhanden ist, so dass das Dispersionskompensationselement (26) eine von der Lichtleitfaser separate optische Einheit bildet, und wobei an einem Ausgang der Dispersionskompensationseinheit (24) ein Polarisationsanpassungselement (28, 48) vorhanden ist, wobei das Polarisationsanpassungselement (28, 48) zum Anpassen eines Polarisationszustandes eines die Dispersionskompensationseinheit (24) verlassenden Laserpulses an eine Polarisationsrichtung der Lichtleitfaser eingerichtet ist, wobei am Ausgang der Dispersionskompensationseinheit (24) ein Lyot-Filter vorhanden ist, welcher einen Polarisator und einen Analysator sowie einen zwischen dem Polarisator und dem Analysator angeordneten doppelbrechenden Kristall umfasst, wobei als Polarisationsanpassungselement (48) der Analysator des Lyot-Filters vorgesehen ist.

2. Ultrakurzpulsfaserlaser (2) nach Anspruch 1, bei dem der Nebenring (6) einen Abschnitt aus einer nichtlinearen Lichtleitfaser (19) umfasst und die Dispersionskompensationseinheit (24) in dem Nebenring (6) angeordnet ist, wobei ferner insbesondere ein als laseraktives Medium ausgebildeter Faserabschnitt (10) in dem Nebenring (6) vorgesehen ist.

3. Ultrakurzpulsfaserlaser (2) nach einem der vorhergehenden Ansprüche, bei dem der Hauptring (4) und der Nebenring (6) über einen Koppler (8) gekoppelt sind, wobei die Dispersionskompensationseinheit (24) im Nebenring (6) direkt anschließend zu dem Koppler angeordnet ist.

4. Ultrakurzpulsfaserlaser (2) nach Anspruch 2, bei dem die Dispersionskompensationseinheit (24) und der Abschnitt aus der nichtlinearen Lichtleitfaser (19) unmittelbar benachbart zueinander angeordnet sind, so dass ein in dem Nebenring (6) propagierender Laserpuls, welcher zur Kompensation seiner Gruppenlaufzeitdispersion die Dispersionskompensationseinheit (24) durchlaufen hat, direkt anschließend in den Abschnitt aus der nichtlinearen Lichtleitfaser (19) eintritt, wobei der Nebenring (6) kein laseraktives Medium umfasst.

5. Ultrakurzpulsfaserlaser (2) nach einem der vorhergehenden Ansprüche, bei dem eine erste Dispersionskompensationseinheit (24a) im Hauptring (4) und eine zweite Dispersionskompensationseinheit (24b) im Nebenring (6) vorhanden sind.

6. Ultrakurzpulsfaserlaser (2) nach Anspruch 2 oder 4, bei dem der Abschnitt aus der nichtlinearen Lichtleitfaser (19) ein hochnichtlinearer Lichtleitfaserabschnitt ist, wobei der Fasernichtlinearitätsfaktor des hoch-nichtlinearen Lichtleitfaserabschnitts größer als drei, insbesondere größer als fünf, ferner insbesondere größer als sieben, weiterhin insbesondere größer als acht, weiterhin insbesondere größer als zehn und ferner insbesondere größer als dreizehn ist, wobei der Fasernichtlinearitätsfaktor in der Einheit 1 / (W * km) betrachtet wird.

7. Ultrakurzpulsfaserlaser (2) nach einem der vorhergehenden Ansprüche, bei dem im Hauptring (4) ein optischer Zirkulator (58) mit einem ersten bis dritten Anschluss vorhanden ist, wobei der Zirkulator (58) derart in den Hauptring (4) integriert ist, dass in dem Hauptring (4) in einer Propagationsrichtung (P) propagierende Laserpulse am ersten Anschluss in den Zirkulator (58) eingekoppelt und von dem Zirkulator (58) an den zweiten Anschluss weitergeleitet werden, wobei mit dem zweiten Anschluss ein Verzögerungs-Faserabschnitt (60) des Hauptrings (4) gekoppelt ist, an dessen dem Zirkulator (58) abgewandtem Ende ein Umkehrspiegel (62) vorhanden ist, der dazu eingerichtet ist, den Verzögerungs-Faserabschnitt (60) durchlaufende Laserpulse zurück in den Verzögerungs-Faserabschnitt (60) zu reflektieren, und wobei Laserpulse, welche den Verzögerungs-Faserabschnitt (60) von dem Umkehrspiegel (62) kommend durchlaufen haben am zweiten Anschluss in den Zirkulator (58) eingekoppelt und von dem Zirkulator (58) an den dritten Anschluss weitergeleitet werden, so dass der Laserpuls in der Propagationsrichtung im Hauptring (4) propagiert.

8. Ultrakurzpulsfaserlaser (2) nach Anspruch 7, bei dem der Umkehrspiegel (62) gleichzeitig als Auskoppelspiegel zum Auskoppeln der im Resonator propagierenden Laserpulse ausgestaltet ist.

9. Ultrakurzpulsfaserlaser (2) nach einem der vorhergehenden Ansprüche, wobei die Dispersionskompensationseinheit (24) als Dispersionskompensationselement (26) zumindest eines der folgenden optischen Elemente umfasst:
zumindest einen gechirpten Spiegel (30, 32), insbesondere zwei zueinander plan-parallel angeordnete gechirpte Spiegel (30,32),
zumindest einen Gires-Tournois-Interferometer (GTI) - Spiegel, insbesondere zwei zueinander plan-parallel angeordnete Gires-Tournois-Interferometer (GTI) - Spiegel,
zumindest ein optisches Gitter (36, 38), insbesondere zwei zueinander plan-parallel angeordnete optische Gitter (36, 38) und einen Umkehrspiegel (44),
zumindest ein Volumen-Bragg-Gitter,
zumindest ein Prisma,
zumindest ein Gitterprisma,
zumindest ein gechirptes Faser-Bragg-Gitter.

10. Ultrakurzpulsfaserlaser (2) nach Anspruch 9, wobei der zumindest eine gechirpte Spiegel (30, 32), insbesondere die beiden gechirpten Spiegel (30, 32), hochdispersive gechirpte Spiegel (30, 32) sind.

11. Ultrakurzpulsfaserlaser (2) nach einem der vorhergehenden Ansprüche, außerdem umfassend einen außerhalb des Resonators vorhandenen externen Pulskompressor (56).

12. Ultrakurzpulsfaserlaser (2) nach einem der vorhergehenden Ansprüche, bei dem die Dispersionskompensationseinheit (24) als Dispersionskompensations- und Auskoppeleinheit (64) ausgebildet ist und hierzu einen, insbesondere als nicht-faserbasiertes diskretes optisches Element ausgebildeten, Auskoppler umfasst.

13. Ultrakurzpulsfaserlaser (2) nach Anspruch 12, wobei der Auskoppler ebenfalls als Polarisationsanpassungselement wirkt.

## Claims

1. A passively mode-coupled ultrashort pulse fiber laser (2) for generating ultrashort laser pulses, comprising a resonator in a figure-of-eight configuration, wherein the resonator has a main ring (4) and a secondary ring (6) optically coupled thereto designed as a non-linear Sagnac interferometer, and wherein the main ring (4) and the secondary ring (6) are constructed of polarization-maintaining optical fibers, and the main ring (4) and/or the secondary ring (6) have a fiber section (10) designed as a laser-active medium, wherein the laser-active medium is optically pumped through an externally-coupled pump light source (14) which is also comprised, wherein there is at least one dispersion compensation unit (24) in the resonator for compensating a group delay dispersion of the ultrashort laser pulses, wherein the dispersion compensation unit (24) is a separate optical unit, and wherein the dispersion compensation unit (24) comprises at least one dispersion compensation element (26), and a free beam path (25) at one input and/or an output of the dispersion compensation unit (24) is provided between a first end (34) and/or a second end (46) of the optical fiber of the main ring (4) and/or the secondary ring (6) and the dispersion compensation element (26), such that the dispersion compensation element (26) forms an optical unit separate from the optical fiber, and wherein a polarization adaptation element (28, 48) is provided at an output of the dispersion compensation unit (24), wherein the polarization adaptation element (28, 48) is configured to adapt a polarization state of a laser pulse leaving the dispersion compensation unit (24) to a polarization direction of the optical fiber, wherein a Lyot filter is provided at the output of the dispersion compensation unit (24) that comprises a polarizer and an analyzer, as well as a birefringent crystal arranged between the polarizer and the analyzer, wherein the analyzer of the Lyot filter is provided as the polarization adaptation element (48).

2. The ultrashort pulse fiber laser (2) according to claim 1, wherein the secondary ring (6) comprises a section consisting of a non-linear optical fiber (19), and the dispersion compensation unit (24) is arranged in the secondary ring (6), wherein in particular a fiber section (10) furthermore designed as a laser active medium and is provided in the secondary ring (6).

3. The ultrashort pulse fiber laser (2) according to one of the preceding claims, wherein the main ring (4) and the secondary ring (6) are coupled by a coupler (8), wherein the dispersion compensation unit (24) in the secondary ring (6) is arranged directly adjacent to the coupler.

4. The ultrashort pulse fiber laser (2) according to claim 2, wherein the dispersion compensation unit (24) and the section consisting of the non-linear optical fiber (19) are arranged directly adjacent to each other such that a laser pulse propagating in the secondary ring (6) that has passed through the dispersion compensation unit (24) to compensate for its group delay dispersion subsequently directly enters the section consisting of the non-linear optical fiber (19), wherein the secondary ring (6) does not comprise a laser-active medium.

5. The ultrashort pulse fiber laser (2) according to one of the preceding claims, wherein a first dispersion compensation unit (24a) is provided in the main ring (4), and a second dispersion compensation unit (24b) is provided in the secondary ring (6).

6. The ultrashort pulse fiber laser (2) according to claim 2 or 4, wherein the section of the non-linear optical fiber (19) is a highly non-linear optical fiber section, wherein the fiber non-linearity factor of the highly non-linear optical fiber section is greater than three, in particular greater than five, more particularly greater than seven, more particularly greater than eight, more particularly greater than ten, and more particularly greater than thirteen, wherein the fiber non-linearity factor is considered to be in the unit 1 / (W * km).

7. The ultrashort pulse fiber laser (2) according to one of the preceding claims, wherein an optical circulator (58) with a first to third connection is provided in the main ring (4), wherein the circulator (58) is integrated in the main ring (4) such that laser pulses propagating in the main ring (4) in a direction of propagation (P) are coupled into the circulator (58) at the first connection and are transferred by the circulator (58) to the second connection, wherein a delaying fiber section (60) of the main ring (4) is coupled to the second connection, and a reversing mirror (62) is provided at its end facing away from the circulator (58), the reversing mirror being configured to reflect laser pulses passing through the delaying fiber section (60) back into the delaying fiber section (60), wherein laser pulses that have passed through the delaying fiber section (60) coming from the reversing mirror (62) are coupled at the second connection into the circulator (58) and are transmitted by the circulator (58) to the third connection so that the laser pulse is propagated in the direction of propagation in the main ring (4).

8. The ultrashort pulse fiber laser (2) according to claim 7, wherein the reversing mirror (62) is also designed as a decoupling mirror for decoupling the laser pulses propagating in the resonator.

9. The ultrashort pulse fiber laser (2) according to one of the preceding claims, wherein the dispersion compensation unit (24) as a dispersion compensation element (26) comprises at least one of the following optical elements:
- at least one chirped mirror (30, 32), in particular two chirped mirrors (30, 32) arranged plane-parallel relative to each other,
- at least one Gires-Tournois interferometer (GTI) mirror, in particular at least two Gires-Tournois interferometer (GTI) mirrors arranged plane-parallel relative to each other,
- at least one optical grating (36, 38), in particular two optical gratings (36, 38) arranged plane-parallel relative to each other, and one reversing mirror (44),
- at least one volume Bragg grating,
- at least one prism,
- at least one grating prism,
- at least one chirped fiber Bragg grating.

10. The ultrashort pulse fiber laser (2) according to claim 9, wherein the at least one chirped mirror (30, 32), in particular both chirped mirrors (30, 32), are highly dispersive chirped mirrors (30, 32).

11. The ultrashort pulse fiber laser (2) according to one of the preceding claims, furthermore comprising an external pulse compressor (56) provided outside of the resonator.

12. The ultrashort pulse fiber laser (2) according to one of the preceding claims, wherein the dispersion compensation unit (24) is designed as a dispersion compensation and decoupling unit (64), and comprises a decoupler, in particular designed as a non-fiber-based, discrete optical element.

13. The ultrashort pulse fiber laser (2) according to claim 12, wherein the decoupler also functions as a polarization adaptation element.

## Revendications

1. Laser à fibres (2) à impulsions ultra-courtes couplé en mode passif pour générer des impulsions laser ultra-courtes, comprenant un résonateur à configuration en forme de huit, dans lequel le résonateur comprend un anneau principal (4) et un anneau secondaire (6) qui est relié optiquement à l'anneau principal et est conçu comme un interféromètre de Sagnac non linéaire, et dans lequel l'anneau principal (4) et l'anneau secondaire (6) sont composés de fibres optiques maintenant la polarisation, et l'anneau principal (4) et/ou l'anneau secondaire (6) ont une section de fibres (10) conçue en tant que milieu actif laser, le milieu actif laser étant pompé optiquement par une source lumineuse (14) formant pompe reliée extérieurement qui est également comprise, au moins une unité (24) de compensation de dispersion pour compenser une dispersion retard de groupe des impulsions laser ultra courtes étant présente dans le résonateur, laquelle l'unité de compensation de dispersion (24) étant une unité optique séparée et l'unité de compensation de dispersion (24) comprenant au moins un élément de compensation de dispersion (26), et dans laquelle un trajet de rayon libre (25) est prévu à une entrée et/ou à une sortie de l'unité de compensation de dispersion (24) entre une première extrémité (34) et/ou une deuxième extrémité (46) de la fibre optique de l'anneau principal (4) et/ou de l'anneau secondaire (6) et l'élément de compensation de dispersion (26), de sorte que l'élément de compensation de dispersion (26) forme une unité optique séparée de la fibre optique, et dans lequel un élément d'adaptation de polarisation (28, 48) est prévu à une sortie de l'unité de compensation de dispersion (24), l'élément d'adaptation de polarisation (28, 48) étant agencé pour adapter un état de polarisation d'une impulsion laser quittant l'unité de compensation de dispersion (24) à une direction de polarisation de la fibre optique, un filtre de Lyot étant prévu à la sortie de l'unité de compensation de dispersion (24), lequel filtre comprend un polariseur et un analyseur ainsi qu'un cristal biréfringent disposé entre le polariseur et l'analyseur, l'analyseur du filtre de Lyot étant prévu en tant qu'élément (48) d'adaptation de polarisation.

2. Laser à fibres (2) à impulsions ultra-courtes selon la revendication 1, dans lequel l'anneau secondaire (6) est constitué d'une section en fibre optique non linéaire (19) et l'unité de compensation de dispersion (24) est agencée dans l'anneau secondaire (6), une section de fibre (10) étant en particulier également prévue dans l'anneau secondaire (6) en tant que milieu actif laser.

3. Laser à fibres (2) à impulsions ultra-courtes selon l'une des revendications précédentes, dans lequel l'anneau principal (4) et l'anneau secondaire (6) sont couplés via un coupleur (8), l'unité de compensation de dispersion (24) étant agencée dans l'anneau secondaire (6) de façon directement adjacente au coupleur.

4. Laser à fibres (2) à impulsions ultra-courtes selon la revendication 2, dans lequel l'unité de compensation de dispersion (24) et la section formée par la fibre optique non linéaire (19) sont agencées de façon directement adjacente l'une à l'autre, de sorte qu'une impulsion laser se propageant dans l'anneau secondaire (6), qui est passée au travers de l'unité de compensation de dispersion (24) pour compenser sa dispersion à retard de groupe, entre directement après dans la section formée par la fibre optique non linéaire (19), l'anneau secondaire (6) ne comprenant pas de milieu actif laser.

5. Laser à fibres (2) à impulsions ultra-courtes selon l'une des revendications précédentes, dans lequel une première unité de compensation de dispersion (24a) est présente dans l'anneau principal (4) et une deuxième unité de compensation de dispersion (24b) est présente dans l'anneau secondaire (6).

6. Laser à fibres optique à impulsions ultra-courtes (2) selon la revendication 2 ou la revendication 4, dans lequel la section formée par la fibre optique non linéaire (19) est une section de fibre optique hautement non linéaire, le facteur de non-linéarité de la section de fibre optique hautement non linéaire étant supérieur à trois, en particulier supérieur à cinq, plus particulièrement supérieur à sept, encore plus particulièrement supérieur à sept, encore plus particulièrement supérieur à huit, encore plus particulièrement supérieur à dix, et encore plus particulièrement supérieur à treize, le facteur de non-linéarité de fibre étant considéré comme étant dans l'unité 1 / (W *km).

7. Laser à fibres optiques à impulsions ultra-courtes (2) selon l'une des revendications précédentes, dans lequel un circulateur optique (58) avec une première à une troisième connexion est prévu dans l'anneau principal (4), le circulateur (58) étant intégré dans l'anneau principal (4) de sorte que des impulsions laser se propageant dans une direction de propagation (P) sont couplées dans le circulateur (58) au niveau de la première connexion de l'anneau principal (4) et sont transmises par le circulateur (58) vers la deuxième connexion, une section de fibre à retard (60) de l'anneau principal (4) étant couplée à la deuxième connexion, un miroir inverseur (62), adapté pour réfléchir des impulsions laser passant à travers la section de fibre à retard (60), étant prévu à son extrémité éloignée du circulateur (58), pour réfléchir vers la section de fibre à retard (60), et des impulsions laser, qui ont traversé la partie de fibre à retard (60) provenant du miroir inverseur (62), étant couplées dans le circulateur (58) au niveau de la deuxième connexion et passent du circulateur (58) à la troisième connexion de sorte que l'impulsion laser se propage dans la direction de propagation dans l'anneau principal (4).

8. Laser à fibres (2) à impulsions ultra-courtes selon la revendication 7, dans lequel le miroir inverseur (62) est configuré simultanément comme miroir de découplage pour découpler les impulsions laser qui se propagent dans le résonateur.

9. Laser à fibres (2) à impulsions ultra-courtes selon l'une des revendications précédentes, dans lequel l'unité de compensation de dispersion (24) comprend, en tant qu'élément de compensation de dispersion (26) au moins un des éléments optiques suivants :
au moins un miroir chirpé (30, 32), en particulier deux miroirs chirpés (30, 32) disposés de façon parallèle, en plan, l'un à l'autre,
au moins un miroir interféromètre de Gires-Tournois (GTI), en particulier deux miroirs interféromètres de Gires-Tournois (GTI) disposés de façon parallèle, en plan, l'un à l'autre,
au moins un réseau optique (36, 38), en particulier deux réseaux optiques (36, 38) disposés de façon parallèle, en plan, l'un à l'autre, et un miroir réversible (44),
au moins un réseau de Bragg en volume,
au moins un prisme,
au moins un prisme en réseau,
au moins un réseau de Bragg à fibres chirpées.

10. Laser à fibres (2) à impulsions ultra-courtes selon la revendication 9, **caractérisé en ce que** ledit au moins un miroir chirpé (30, 32), en particulier les deux miroirs chirpés (30, 32), sont des miroirs chirpés (30, 32) hautement dispersifs.

11. Laser à fibres (2) à impulsions ultra-courtes selon l'une des revendications précédentes, comprenant en outre un compresseur d'impulsions externe (56) présent en dehors du résonateur.

12. Laser à fibres (2) à impulsions ultra-courtes selon l'une des revendications précédentes, dans lequel l'unité de compensation de dispersion (24) est conçue comme une unité de compensation de dispersion et de découplage (64) et comprend à cet effet un découpleur, en particulier conçu comme élément optique discret non à base de fibres.

13. Laser à fibres (2) à impulsions ultra-courtes selon la revendication 12, **caractérisé en ce que** le découpleur sert également d'élément d'adaptation de polarisation.
